# NEUE EUROPÄISCHE PATENTSCHRIFT

(11) **EP 2 884 187 B2**
(45) Veröffentlichungstag und Bekanntmachung des Hinweises auf die Entscheidung über den Einspruch: **09.03.2022**
(45) Hinweis auf die Patenterteilung: 01.05.2019
(21) Anmeldenummer: 14196990.7
(22) Anmeldetag: 09.12.2014
(51) Int. Cl.: F24C 7/08, D06F 34/32, G06F 3/044, H03K 17/96

(54) **Verfahren zur Bedienerführung, Blendenbauteil und Herstellung eines Blendenbauteils**
Method for operator guidance, cover component, production of a cover component, household appliance having a cover component
Procédé d'aide à l'utilisateur, composant d'écran, fabrication d'un composant d'écran et appareil ménager doté d'un composant d'écran

(30) Priorität: 10.12.2013 DE 102013113772; 22.04.2014 DE 202014101897 U
(43) Veröffentlichungstag der Anmeldung: 17.06.2015
(73) Patentinhaber: PAS Deutschland GmbH, 16816 Neuruppin (DE)
(72) Erfinder: Krause, Olaf, 16816 Neuruppin (DE)
(74) Vertreter: Witte, Weller & Partner Patentanwälte mbB

(56) Entgegenhaltungen:
- EP-A2- 1 133 057
- EP-A2- 1 273 851
- EP-A2- 1 876 394
- EP-B1- 1 994 216
- DE-A1-102005 018 298
- DE-A1-102005 032 088
- DE-A1-102008 020 995
- DE-A1-102008 026 481
- DE-A1-102008 051 265
- DE-A1-102009 006 224
- DE-A1-102010 060 295
- DE-A1-102011 081 332
- DE-U1-202012 101 770
- US-A1- 2008 235 614
- US-A1- 2011 012 845
- US-B1- 7 030 860
- US-B2- 6 626 013

## Beschreibung

Die Erfindung betrifft ein Verfahren zur selektiven Bedienerführung für Bedienereingaben bei einem Haushaltsgerät. Die Erfindung betrifft ferner ein Blendenbauteil für eine Bedienblende eines Hausgeräts, eine Bedienanordnung mit einem Blendenbauteil, sowie ein Verfahren zur Herstellung eines Blendenbauteils für eine Bedienblende eines Haushaltgeräts. Verschiedene Aspekte der Offenbarung befassen sich ferner mit der Benutzerführung für Bedienereingaben bei Haushaltsgeräten.

Die nachfolgend beschriebenen und erläuterten Ansätze und Ausgestaltungen können insbesondere auf dem Gebiet der Haushaltgeräte vorteilhaft zur Anwendung gelangen. Bei Haushaltsgeräten kann es sich insbesondere um sogenannte "weiße Ware" handeln, also etwa um übliche Geräte zum Kühlen, Waschen, Kochen, Backen und dgl.

Aus der DE 10 2005 018 298 A1 ist ein Verfahren zur Ansteuerung und/oder Auswertung eines länglichen Sensorelementes eines Berührungsschalters einer Bedieneinrichtung für ein Elektrogerät bekannt, wobei ein Berühren bzw. Auflegen eines Fingers oberhalb des Sensorelementes erfasst und ausgewertet wird, wobei in einer ersten Betriebsart ein im wesentlichen stationäres bzw. nicht seitlich bewegtes Auflegen des Fingers als punktartige Betätigung ausgewertet wird mit einem dem Ort der Betätigung zugeordneten Bediensignal, und wobei in einer zweiten Betriebsart ein Betätigen bzw. Auflegen eines Fingers mit einer aufgelegt und ziehend erfolgenden Bewegung entlang der Längsrichtung des Sensorelementes in Abhängigkeit von der Länge und/oder Anfangs- und Endpunkt der Betätigung als ziehende längliche Betätigung ausgewertet wird mit einem dem Längsbereich und/oder der Länge der Betätigung zugeordneten anderen Bediensignal.

Aus der EP 1 133 057 A2 ist ein Berührungsschalter für ein Elektro-Gerät bekannt, der ein LC-Display aufweist. Die EP 1 273 851 A2 zeigt eine Stelleinheit für Gargeräte, mit einem berührungsempfindlichen Stellstreifen, dessen Stellabschnitten Stellwerte oder Stellwertbereiche einer vorbestimmten Stellkurve zugeordnet oder wahlweise zuordenbar sind. Die DE 10 2005 032 088 A1 zeigt ein Gargerät mit einer Bedienanordnung mit zumindest einem berührungsempfindlichen Stellstreifen zur Einstellung einer Stellgröße in einem ersten Bedienmodus in Abhängigkeit von einer Berühr-Position auf dem Stellstreifen, wobei die Bedienanordnung zumindest einen Wahlschalter zum Umschalten von dem ersten Bedienmodus in zumindest einen zweiten Bedienmodus aufweist. Aus der EP 1 994 216 B1 ist eine Bedienblendenanordnung für ein Haushaltsgerät bekannt, die eine Schaltungsanordnung mit drei oder mehr separaten Elektroden aufweist, wobei eine Auswerteeinheit vorgesehen ist, die mittels Triangulation die Raumlage eines Bedienerfingers ermittelt. Aus der DE102011 081 332 A1 ist ein Haushaltsgerät mit einer berührungssensitiven Bedien- und Anzeigeeinrichtung bekannt, die eine Anzeigeeinheit zum Anzeigen von Bedieninformationen und ein transparentes Trägerteil aufweist, an dem eine kapazitive Sensorelektrode als Teil eines Berührungskondensators angeordnet ist, wobei die Sensorelektrode aus einem transparenten und elektrisch leitfähigen Lack oder Kleber ausgebildet ist.

Blendenanordnungen bzw. Bedienblenden bei Haushaltsgeräten können üblicherweise Schnittstellen zur Benutzerinteraktion aufweisen. Dabei kann es sich etwa um Displays, Kontrollleuchten, Drehschalter, Druckknöpfe, Drucktaster, berührungsempfindliche Oberflächen oder Anzeigen sowie um zugehörige Beschriftungen bzw. Symbole handeln. Konventionelle Eingabeelemente wie etwa Knöpfe oder Schalter führen häufig zu einem gewissen Aufwand bei der Herstellung von Bedienblenden und Blendenanordnungen. Dieser Aufwand ist umso höher, je mehr Möglichkeiten zur Benutzerinteraktion vorgesehen sind, also je mehr Benutzereingaben möglich sind. Ferner kann eine deutliche Erhöhung der Anzahl an Schaltern, Knöpfen oder dergleichen die Bedienung des Haushaltsgeräts erschweren.

Im Stand der Technik sind verschiedene Ansätze bekannt, um eine Mehrzahl von Bedienereingaben an lediglich einer "Bedienerschnittstelle" zu ermöglichen. So offenbart beispielsweise die DE 10 2008 032 451 A1 ein Gargerät sowie ein Verfahren zur Bedienung eines Gargeräts, wobei das Gargerät ein Eingabedisplay aufweist, das als Touchscreen ausgebildet ist und verschiedene Informationen graphisch darstellen kann. Insbesondere wird darauf abgestellt, Informationen in Form von graphischen Visualisierungen und/oder Animationen darzustellen. Eine solche Gestaltung ist jedoch mit einem hohen Aufwand verbunden und eignet sich daher vorrangig nur für High-End Geräte sowie für Geräte für den professionellen Einsatz. Aus der DE 10 2010 060 295 A1 ist ein programmgesteuertes Haushaltgerät mit einer Bedien- und Anzeigevorrichtung bekannt, die eine berührungsempfindlichen Anzeigefläche in Form eines Touchscreens aufweist, in der Programme und Programmparameter anzeigbar und mittels Berührung entsprechender Bedien- und Anzeigefelder durch einen Benutzer auswählbar und/oder veränderbar sind. Die Anzeigefläche weist eine sich über ihre Breite erstreckende Bedien- und Anzeigeleiste, ein sich unterhalb der Statusleiste erstreckendes Bedien- und Anzeigefeld sowie eine sich unterhalb des Arbeitsbereichs erstreckende Bedien- und Anzeigeleiste auf.

Es ist daher eine Aufgabe der vorliegenden Erfindung, ein Verfahren zur selektiven Bedienerführung bei einem Haushaltsgerät, ein zur Durchführung des Verfahrens geeignetes Blendenbauteil, insbesondere eine Bedienblende für ein Haushaltsgerät, eine Bedienanordnung mit einem Blendenbauteil sowie ein korrespondierendes Verfahren zur Herstellung eines solchen Blendenbauteils anzugeben, die mit geringem Aufwand realisierbar sind und gleichwohl eine erweiterte Benutzerinteraktion erlauben können. Insbesondere soll das Blendenbauteil für eine Vielzahl von Varianten und Konfigurationen geeignet sein, um den Fertigungsaufwand auch bei verhältnismäßig geringen Losgrößen begrenzen zu können. Ferner soll möglichst eine Bedienerführung gewährleistet werden, die die Bedienung und Benutzung des Haushaltsgeräts erleichtert. Schließlich sollen die Blendenanordnung sowie das Haushaltsgerät mit einer derartigen Blendenanordnung eine hochwertige, integrierte Gestaltung aufweisen und somit möglichst durch den Bediener als optisch hochwertig wahrgenommen werden.

Das Bedienverfahren betreffend wird die Aufgabe der Erfindung gelöst durch ein Verfahren zur selektiven Bedienerführung für Bedienereingaben bei einem Haushaltsgerät gemäß Anspruch 1.

Die Aufgabe der Erfindung wird auf diese Weise vollkommen gelöst.

Das Blendenbauteil betreffend wird die Aufgabe der Erfindung gelöst durch ein Blendenbauteil für eine Bedienblende für ein Haushaltsgerät gemäß Anspruch 4.

Auch auf diese Weise wird die Aufgabe der Erfindung vollkommen gelöst

Das Herstellungsverfahren betreffend wird die Aufgabe der Erfindung gelöst durch ein Verfahren zur Herstellung eines Blendenbauteils einer Bedienblende für ein Haushaltsgerät gemäß Anspruch 13.

Auch auf diese Weise wird die Aufgabe der Erfindung vollständig gelöst.

Erfindungsgemäß kann nämlich die Sensorschicht für einen Bediener "unsichtbar" hinter der Abdeckschicht angeordnet werden, wobei die Sensorschicht einen Bereich, insbesondere eine Fläche, definiert, in dem Bedienereingaben potentiell erfasst werden können. Bei der Herstellung bzw. im Betrieb kann nunmehr ein Abschnitt der Sensorschicht bewusst gewählt und aktiviert werden, um dort Benutzereingaben erfassen und auswerten zu können. Mit anderen Worten kann das Blendenbauteil eine Basiskonfiguration aufweisen und je nach gewünschter Ausgestaltung variantenspezifisch angesteuert werden. So ist es etwa vorstellbar, lediglich einen oder mehrere (Flächen-) Abschnitte der Sensorschicht bei der gewählten Variante tatsächlich zur Erfassung und Auswertung der Bedienereingaben heranzuziehen. Auf diese Weise kann eine hohe Variantenvielfalt beim Blendenbauteil mit geringem Aufwand ermöglicht werden.

Ferner kann die Ansteuerung bzw. Zuweisung der Sensorschicht bzw. der gewählten Abschnitte der Sensorschicht im Betrieb abhängig vom aktuell gewünschten Eingabemodus erfolgen. Dies heißt mit anderen Worten, ein und dieselbe Sensorschicht bzw. Abschnitte davon können für verschiedene Eingaben gewählt werden. Mit anderen Worten kann etwa bei einer Waschmaschine ein bestimmter gewählter Abschnitt der Sensorschicht sowohl zur Auswahl eines Waschprogramms (erster Eingabemodus) als auch zur Auswahl einer Waschtemperatur (zweiter Eingabemodus) herangezogen werden. Dieses Beispiel ist lediglich stellvertretend für eine Vielzahl von denkbaren Kombinationen und Konfigurationen zur Veranschaulichung angeführt.

Die Sensorschicht ist an der im Einbauzustand vom Bediener abgewandten Seite der Abdeckschicht des Blendenbauteils angeordnet. Demgemäß führt es nicht zu optischen Beeinträchtigungen, wenn lediglich ein Teilabschnitt der Sensorschicht tatsächlich zur Erfassung und Auswertung von Bedienereingaben herangezogen wird.

Gemäß verschiedenen Aspekten der vorliegenden Offenbarung ist das Blendenbauteil mit einer Anzeigeschicht (oder: Anzeigeebene) versehen, die (von der Abdeckschicht her betrachtet) hinter der Sensorschicht angeordnet ist. Mit anderen Worten sind die Anzeigeschicht und die Sensorschicht zumindest abschnittsweise übereinander angeordnet. Die Anzeigeschicht ist aus zumindest einem diskreten Anzeigeelement gebildet. Im Sinne der vorliegenden Offenbarung kann es sich bei einem diskreten Anzeigeelement insbesondere um ein optisches Anzeigeelement handeln, das zur Darstellung einer begrenzten Menge an Informationen ausgebildet ist. Bei einem diskreten Anzeigeelement handelt es sich nicht um eine graphische Anzeige, die dazu ausgebildet ist, aus Pixeln generierte Bilder darzustellen. Bei einem diskreten Anzeigeelement im Sinne der vorliegenden Offenbarung handelt es sich um Statussymbole, Kontrollanzeigen, Kontroll-LEDs, Balkenanzeigen, Segmentanzeigen und ähnliche "diskrete" Anzeigeelemente. Diskrete Anzeigeelemente sind üblicherweise deutlich günstiger als pixelbasierte graphische Anzeigeelemente. Ferner weisen diskrete Anzeigeelemente regelmäßig eine höhere Robustheit und Eignung für schwankende Umgebungsbedingungen auf. Mit anderen Worten kann auch ohne ein pixelbasiertes Display eine Vielzahl von Informationen dargestellt werden. Dem Bediener kann das Gefühl vermittelt werden, unmittelbar auf die Anzeige einzuwirken, da er direkt im Bereich der aktivierten bzw. aktivierbaren diskreten Anzeigeelementen Eingaben vornehmen kann.

Gemäß verschiedenen Aspekten der vorliegenden Offenbarung kann also zumindest ein diskretes Anzeigeelement, vorzugsweise eine Mehrzahl diskreter Anzeigeelemente, die die Anzeigeschicht definieren, "hinter" der Sensorschicht angeordnet werden. Das zumindest eine diskrete Anzeigeelement kann im Zusammenhang mit der Befähigung zur Zuweisung und Aktivierung von Abschnitten der Sensorschicht zur selektiven Bedienerführung bzw. Bedieneranleitung herangezogen werden. Beispielhaft kann zumindest ein diskretes Anzeigeelement selektiv aktiviert werden, um ein optisches Signal auszugeben, das dem Bediener zeigt, dass er im Bereich des aktivierten Anzeigeelements Eingaben vornehmen kann, die durch die (verdeckte) Sensorschicht erfasst werden.

Vorzugsweise ist das Blendenbauteil, insbesondere dessen Sensorschicht, dazu ausgebildet, analoge oder quasi-analoge Eingaben des Bedieners zu erfassen. Dies heißt mit anderen Worten, es ist bevorzugt, wenn die Sensorschicht nicht nur dazu herangezogen wird, bestimmte Funktionen (digital) an- oder auszuschalten. Vielmehr wird es ermöglicht, erweiterte Benutzereingaben, insbesondere Benutzergesten, zu erfassen, die beispielsweise die Wahl eines Wertes innerhalb eines Wertebereichs erlauben. Auf diese Weise kann sich die Bedienung des Haushaltsgeräts deutlich vereinfachen. Beispielsweise kann der Bediener innerhalb eines verhältnismäßig breiten Temperaturbereichs eine Zieltemperatur durch einfaches "Wischen" entlang der Abdeckschicht auswählen. Der Bediener kann jedoch ferner, in einem anderen Betriebsmodus, im selben Bereich etwa eine Programmwahl vornehmen, wenn ihm dies durch ein entsprechendes aktiviertes diskretes Anzeigeelement angezeigt wird.

Bedienereingaben können allgemein eine Annäherung an die Abdeckschicht und/oder eine Berührung der Abdeckschicht umfassen. Bedienereingaben können ferner punktuell erfolgen (etwa im Sinne eines Klicks oder eines Doppelklicks). Bedienereingaben können jedoch auch Bewegungspfade umfassen, wie etwa Wischbewegungen, Kreisbewegungen oder dergleichen. Bedienereingaben können grundsätzlich mit einem Hilfsmittel, etwa einem Stift, oder mittels Körperteilen, insbesondere mittels Fingern oder Daumen, vorgenommen werden. Bedienereingaben können auch kombiniert werden, um komplexe Funktionen zu ermöglichen. Hierbei kann es sich beispielsweise um eine Zoom-Funktion, also etwa eine Vergrößerungs- oder Verkleinerungsfunktion, handeln. Mittels solcher komplexer Gesten kann etwa die Empfindlichkeit der Sensorschicht für bestimmte Bedienereingaben beeinflusst werden. Andere erweiterte/komplexe Eingaben sind denkbar. Beispielhaft kann mittels einer Zoom-Geste die Empfindlichkeit für Wisch-Gesten, beispielsweise zur Temperaturwahl oder Zeitwahl, beeinflusst werden.

Im Sinne der vorliegenden Offenbarung kann der Begriff Bedienerführung eine Anleitung bzw. Anweisung zur Eingabe an den Bediener, ferner jedoch auch eine Rückmeldung an den Bediener nach erfolgter Eingabe umfassen. Eine Anleitung kann etwa dann gegeben sein, wenn ein aktiviertes diskretes Anzeigeelement einen bestimmten Bereich der (verdeckten) Sensorschicht kennzeichnet oder hervorhebt, der aktuell zur Erfassung von Bedienergesten aktiviert ist. Eine Rückmeldung an den Bediener kann etwa eine bestimmte optische Ausgabe umfassen, mit der auf eine bestimmte Bedienereingabe reagiert wird. Dies kann etwa die Veränderung einer Balkenanzeige umfassen, die als diskretes Anzeigeelement ausgebildet ist. Ferner kann die optische Ausgabe etwa eine Farbänderung eines diskreten Anzeigeelements umfassen. Auf diese Weise können mit - für sich genommen - relativ einfach gestalteten Anzeigeelementen komplexe Informationen dargestellt werden. Es kann eine hinreichend detaillierte Benutzerinteraktion erfolgen, dies kann die durch den Bediener empfundene Wertigkeit steigern.

Es ist bevorzugt, wenn die Abdeckschicht des Blendenbauteils die Sensorschicht vollständig bedeckt. Bei der Abdeckschicht handelt es sich insbesondere um eine im Wesentlichen geschlossene Abdeckschicht, die die Sensorschicht vollständig abdeckt. Die Sensorschicht ist vorzugsweise an der Rückseite der Abdeckschicht angeordnet, also an der im Normalbetrieb vom Bediener abgewandten Seite der Abdeckschicht.

Das Fertigungsverfahren zur Herstellung des Blendenbauteils erlaubt eine große Flexibilität bei der Herstellung. Da mittels der abschnittsweise aktivierbaren Sensorschicht eine große potentiell aktivierbare Sensorfläche bereitgestellt werden kann, können von dieser durch geeignete Kontaktierung bzw. Ansteuerung (jeweils gemäß der aktuell gewünschten Konfiguration) gezielt Abschnitte für Benutzereingaben ausgewählt werden. Das Einbringen der abschnittsweise aktivierbaren Sensorschicht ist nicht mit wesentlichem Mehraufwand verbunden. Vielmehr können sich Kostenvorteile in der Herstellung ergeben, da auf Basis einer Grundkonfiguration eine Vielzahl von Varianten realisiert werden kann. Die Varianten können sich etwa in der Funktionsvielfalt voneinander unterscheiden. Unabhängig davon, ob das herzustellende Haushaltsgerät einen geringen, einen mittleren oder gar einen hohen Funktionsumfang hat, können die erforderlichen Bedienereingaben in einfacher Weise durch die Konfiguration und Ansteuerung der aktivierbaren Sensorschicht erfasst und ausgewertet werden.

Beispielhaft kann das Blendenbauteil in der genannten Weise mit der Sensorschicht versehen werden und an seiner dem Bediener zugewandten Seite bedruckt oder in sonstiger Weise behandelt werden, um für den Bediener wahrnehmbare Bediensymbole zu erzeugen. Auf Basis des aktuell gewählten Layouts der Bedruckung oder Bearbeitung kann nun softwaremäßig bzw. steuerungstechnisch ein hierzu korrespondierendes Layout der Sensorschicht zur selektiven Aktivierung gewählt werden. Mit anderen Worten kann etwa eine Steuereinrichtung derart gestaltet und ausgelegt werden, dass Bedienereingaben nur in den Bereichen der Sensorschicht erfasst werden, die mit den an der Abdeckschicht erzeugten Bedienersymbolen korrespondieren. Die entsprechende Zuordnung der gewählten Abschnitte der Sensorschicht kann in einfacher Weise softwaremäßig oder schaltungstechnisch realisiert werden. Mit anderen Worten kann ein frei skalierbares Bedienfeld erzeugt werden. Das Bedienfeld kann seine Funktionszuweisung am Ende des Produktionsprozesses erhalten.

Das Verfahren zur Herstellung des Blendenbauteils kann durch die folgenden Schritte weitergebildet werden:
- Bereitstellung zumindest eines diskreten Anzeigeelements,
- Fügen der Abdeckschicht, der Sensorschicht und des zumindest einen diskreten Anzeigeelements, wobei die Sensorschicht der Abdeckschicht und dem zumindest einen diskreten Anzeigeelements zwischengeordnet wird, und
- Bereitstellen einer Schnittstelle für eine Steuereinrichtung zur Ansteuerung des zumindest einen diskreten Anzeigeelements und zur Auswertung von an der Sensorschicht erfassten Bedienereingaben zur selektiven Bedienerführung.

Bei der Schnittstelle kann es sich etwa um eine Kontaktierung der Sensorschicht handeln, über die die Steuereinrichtung mit der Sensorschicht kommuniziert. Ferner kann die Schnittstelle eine Kontaktierung der Steuereinrichtung mit dem zumindest einen diskreten Anzeigeelement umfassen, so dass die Steuereinrichtung das zumindest eine diskrete Anzeigeelement selektiv aktivieren oder deaktivieren kann.

Das Verfahren kann ferner den folgenden Schritt umfassen:
- Zuweisen zumindest eines definierten auszuwertenden Feldes für Bedienereingaben, insbesondere Bedienergesten, auf der Sensorschicht zur Definition eines aktuellen Eingabemodus in Abhängigkeit von dem gewünschten Eingabemodus.

Alternativ oder zusätzlich kann das Verfahren durch die folgenden Schritte weitergebildet sein:
- Bearbeitung der Abdeckschicht insbesondere Bedruckung oder Beschichtung, zur Erzeugung zumindest eines optisch und/oder haptisch wahrnehmbaren Bediensymbols zu Bedienerführung, und
- Zuweisen zumindest eines auszuwertenden Feldes für Bedienereingaben auf der Sensorschicht in Abhängigkeit von einer Größe und/oder Anordnung des zumindest einen optisch und/oder haptisch wahrnehmbaren Bediensymbols zur selektiven Bedienerführung.

Mit anderen Worten kann die Bedienerführung mittels selektiv aktivierbarer Elemente, dem zumindest einem diskreten Anzeigeelement, sowie mit permanent vorhandenen Elementen, dem zumindest einen optisch und/oder haptisch wahrnehmbaren Bediensymbol, erfolgen. Beide Arten von Elementen können in vorteilhafter Weise miteinander kombiniert werden.

In bevorzugter Weiterbildung des Blendenbauteils ist die Sensorschicht als kapazitive Sensorschicht ausgebildet, wobei die Sensorschicht insbesondere dazu ausgebildet ist, Berührungen auf der Abdeckschicht und/oder Annäherungen an die Abdeckschicht im Bereich der Sensorschicht zu erfassen.

Mit anderen Worten kann die Sensorschicht etwa als projiziert-kapazitive Sensorschicht ausgestaltet sein. Die Sensorschicht kann insbesondere als folienbasierte Sensorschicht ausgestaltet sein. Es versteht sich, dass andere Funktionsprinzipien für die Sensorschicht zur Erfassung von Berührungen und/oder Annäherungen an die Abdeckschicht genutzt werden können. Beispielhaft kann die Sensorschicht als induktive Sensorschicht, resistive Sensorschicht, als optische Sensorschicht und/oder als kombinierte Sensorschicht ausgestaltet sein.

Die Sensorschicht kann insbesondere zwei voneinander isolierte Ebenen umfassen, die jeweils mit leitfähigem Material versehen sind. Beispielhaft kann eine erste Ebene eine Zeilenstruktur und eine zweite Ebene eine Spaltenstruktur aufweisen. Andere Gestaltungen wie etwa Rauten oder Ähnliches sind denkbar. Es ist besonders bevorzugt, wenn die Sensorschicht dazu ausgestaltet ist, mehrdimensionale Bedienergesten und/oder mehrere Bedienereingaben gleichzeitig zu erfassen. Mehrdimensionale Bedienergesten können etwa Wischbewegungen umfassen. Die Fähigkeit zur gleichzeitigen Erfassung mehrerer Bedienereingaben kann etwa als Multi-Touch-Fähigkeit bezeichnet werden.

Es ist ferner bevorzugt, wenn das Blendenbauteil eine Schnittstelle für eine Steuereinrichtung umfasst, die dazu ausgebildet ist, die Sensorschicht und das zumindest eine diskrete Anzeigeelement selektiv anzusteuern, um eine Mehrzahl von Eingabemodi zu definieren. Das zumindest eine diskrete Anzeigeelement kann selektiv aktiviert werden, um einem Bediener anzuzeigen, dass eine bestimmte Art von Eingabe an einen bestimmten Ort der Sensorschicht vorgenommen werden kann. Über die Schnittstelle kann die Steuereinrichtung gezielt einen Abschnitt der Sensorschicht für Eingaben aktivieren und entsprechend auswerten.

Gemäß einer weiteren Ausgestaltung des Blendenbauteils ist die Steuereinrichtung dazu ausgebildet, einen aktuellen Eingabemodus zu definieren, wobei die Steuereinrichtung ferner dazu ausgebildet ist, unter Berücksichtigung zumindest eines gewählten Eingabemodus zumindest ein auszuwertendes Feld für Bedienereingaben auf der Sensorschicht zuzuweisen. Dies kann in vorteilhafter Weise mit der Aktivierung zumindest eines diskreten Anzeigeelements einhergehen, um dem Bediener anzuzeigen, wo er seine Eingaben vornehmen kann, und welche Art von Eingabe aktuell erforderlich ist.

Mit anderen Worten kann es von Vorteil sein, ein System zur Erfassung von Bedienereingaben zu bilden, das zumindest ein Blendenbauteil und zumindest eine Steuereinrichtung nach einem der vorgenannten Aspekte umfasst. Ein solches System kann einerseits als diskretes Bauteil gebildet werden. Andererseits ist es vorstellbar, die Steuerungsfunktion zur Ansteuerung des Blendenbauteils an eine (übergeordnete) Steuereinrichtung des Haushaltsgeräts auszulagern. Demgemäß kann das System während der Montage durch Fügen des Blendenbauteils zur Vervollkommnung des Haushaltsgerätes gebildet werden.

Gemäß einer weiteren Ausgestaltung des Blendenbauteils umfasst die Anzeigeschicht zumindest ein Anzeigeelement, das als diskretes, selektiv aktivierbares Symbol oder als diskrete, selektiv aktivierbare Segment-Anzeige ausgebildet ist, insbesondere als Sieben-Segment-Anzeige. Bei einem selektiv aktivierbaren Symbol kann es sich etwa um eine Leuchtdiode oder eine Ansammlung von Leuchtdioden handeln. Das selektiv aktivierbare Symbol kann ferner eine Symboldarstellung umfassen, etwa eine mittels einer LED oder einer ähnlichen Leuchtquelle beleuchtbare Silhouette bzw. ein Piktogramm. Eine selektiv aktivierbare Segment-Anzeige kann etwa eine Balkenanzeige, eine Kreissegmentanzeige, eine Mehr-Segment-Anzeige zur Darstellung alphanumerischer Informationen oder Ähnliches umfassen. In vorteilhafter Weise können verschieden Anzeigetypen miteinander kombiniert werden, um das zumindest eine Anzeigeelement zu bilden. Das zumindest eine Anzeigeelement kann insbesondere an eine erwartete Benutzereingabe angepasst werden. So kann etwa eine Wischfunktion mit einer Balkensegmentanzeige und/oder einer alphanumerischen Segmentanzeige kombiniert werden. Durch das Wischen entlang des aktuell aktivierten Abschnitts der Sensorschicht kann der Bediener den unmittelbar angezeigten Wert beeinflussen, so dass eine direkte Rückmeldung an den Bediener gegeben ist. Das zumindest eine Anzeigeelement kann auch ein Begrenzung des aktuell definierten Feldes veranschaulichen.

Gemäß verschiedenen Ausgestaltungen ist es ferner bevorzugt, wenn die Abdeckschicht und die Sensorschicht zumindest abschnittsweise transparent oder transluzent gestaltet sind. Mit anderen Worten können die Abdeckschicht und die Sensorschicht zumindest abschnittsweise optisch durchlässig sein und somit die optische Wahrnehmung des zumindest einen diskreten Anzeigeelements, das sowohl von der Sensorschicht als auch von der Abdeckschicht verdeckt sein kann, verbessern. Die Abdeckschicht und die Sensorschicht können zumindest teilweise transparent oder transluzent gestaltet sein, so dass etwa dann, wenn ein diskretes Anzeigeelement gerade nicht aktiviert ist, dieses für den Bediener nicht wahrnehmbar ist. Auf diese Weise kann die Bedienung des Haushaltsgeräts weiter vereinfacht werden, da aktuell nicht benötigte diskrete Anzeigeelemente "unsichtbar" gemacht werden können.

Gemäß einer weiteren Ausgestaltung des Blendenbauteils ist die Abdeckschicht zumindest abschnittsweise oberflächenbehandelt, insbesondere bedruckt oder beschichtet, wobei die Abdeckschicht zumindest ein optisch und/oder haptisch wahrnehmbares Bediensymbol zur Bedienerführung aufweist. Beispielhaft kann die Abdeckschicht bedruckt sein. Alternativ oder zusätzlich kann die Abdeckschicht mit erhabenen oder vertieften Gestaltelementen versehen sein. Ferner ist es vorstellbar, die Oberflächenbeschaffenheit der Abdeckschicht gezielt zu beeinflussen, um das zumindest eine Bediensymbol deutlich hervorzuheben. Die genannten Maßnahmen können miteinander kombiniert werden.

Auf diese Weise kann das Blendenbauteil alternativ oder zusätzlich zu den selektiv aktivierbaren diskreten Anzeigeelementen mit permanent sichtbaren Elementen versehen sein, um dem Bediener Eingabemöglichkeiten zu kennzeichnen. Das zumindest eine optisch und/oder haptisch wahrnehmbare Bediensymbol kann etwa eine graphische Darstellung und/oder eine alphanumerische Darstellung umfassen. Insbesondere ist die Verwendung von Piktogrammen vorstellbar. Dem zumindest einen Bediensymbol der Abdeckschicht kann bei der Sensorschicht ein entsprechendes Feld oder ein Abschnitt zugeordnet werden, in dem Benutzereingaben, die mit dem Bediensymbol verknüpft sind, erfasst werden können.

Ein Blendenbauteil nach einem der vorgenannten Aspekte kommt bei einem Haushaltsgerät zur Verwendung.

Das Verfahren zur selektiven Bedienerführung kann durch den folgenden Schritt weiter gebildet werden:
- Aktivieren zumindest eines diskreten Anzeigeelements einer Anzeigeschicht, die auf der der Abdeckschicht abgewandten Seite der Sensorschicht angeordnet ist, zur Kennzeichnung des auszuwertenden Feldes der Sensorschicht.

Es ist besonders bevorzugt, wenn das definierte auszuwertende Feld dem aktivierten diskreten Anzeigeelement zumindest benachbart ist. Insbesondere ist es bevorzugt, wenn sich das zugewiesene auszuwertende Feld (aus Sicht des Bedieners) vor dem aktivierten diskreten Anzeigeelement befindet. Auf diese Weise kann sich für den Bediener der Eindruck ergeben, direkt beim Anzeigeelement die gewünschten Eingaben vornehmen zu können, etwa eine Auswahl oder eine Änderung eines Wertes.

Gemäß einer weiteren vorteilhaften Ausgestaltung des Verfahrens zur Bedienerführung umfasst der Schritt der Definition des aktuellen Eingabemodus ferner den Schritt des Zuordnens des auszuwertenden Feldes für Bedienereingaben zu einem Bediensymbol, das auf der Abdeckschicht optisch und/oder haptisch wahrnehmbar ist. Auf diese Weise können auch permanent wahrnehmbare Symbole zur Anleitung und Führung des Bedieners herangezogen werden. Vorzugsweise können permanent sichtbare Elemente und selektiv aktivierbare Elemente miteinander kombiniert werden, um den Bedienerkomfort weiter zu steigern und die Gefahr von Fehlbedienungen verringern zu können. Es ist ferner bevorzugt, das Verfahren zur selektiven Bedienerführung um den Schritt des Ausgebens einer Rückmeldung an den Bediener, insbesondere einer visuellen Rückmeldung, durch selektives Aktivieren zumindest eines diskreten Anzeigeelements der Anzeigeschicht zu erweitern. Das Aktivieren des zumindest einen diskreten Anzeigeelements kann etwa auch ein Verändern des zumindest einen diskreten Anzeigeelements umfassen. Dies kann beispielhaft eine Farbänderung umfassen. Ferner kann dies auch eine Änderung einer diskreten Balkenanzeige oder Segmentanzeige umfassen.

Es ist besonders bevorzugt, wenn sich das zu Zwecken der Rückmeldung an den Bediener aktivierte diskrete Anzeigeelement aus Sicht des Bedieners im aktuell zugewiesenen Feld oder zumindest in der Nähe des aktuell zugewiesenen Feldes befindet, so dass sich der Eindruck einer direkten Rückkopplung ergibt. Dies kann die wahrgenommene Wertigkeit des Haushaltsgeräts und des Bedienvorganges weiter steigern.

Gemäß einem weiteren Aspekt der Offenbarung wird die Aufgabe durch eine Bedienanordnung für ein Haushaltsgerät mit einem Blendenbauteil gemäß einer Ausgestaltung der vorliegenden Offenbarung gelöst, wobei die Bedienanordnung eine Mehrzahl definierter Bedienbereiche umfasst, die insbesondere am Blendenbauteil ausgebildet sind, und wobei jedem Bedienbereich zumindest ein Feld für Bedienereingaben sowie zumindest ein Anzeigeelement zugeordnet ist. Auf diese Weise kann sich eine integral gestaltete Bedienanordnung ergeben, die eine erweiterte Funktionalität ermöglicht.

Gemäß einer Ausgestaltung der Bedienanordnung ist das Blendenbauteil als integrales Blendenbauteil ausgestaltet, in das die Bedienbereiche integriert sind, wobei zumindest ein erster Bedienbereich und ein zweiter Bedienbereich vorgesehen sind, wobei der erste Bedienbereich einen mittels Gesten steuerbaren Stellregler und Anzeigeelemente zur visuellen Hervorhebung eines Stellbereichs umfasst, und wobei der zweite Bedienbereich eine multifunktionale Anzeige mit zumindest einem Anzeigeelement umfasst, die zumindest dazu ausgebildet ist, einen am ersten Bedienbereich gewählten Wert anzuzeigen. Dem ersten Bedienbereich und dem zweiten Bedienbereich können Felder auf ein- und derselben Sensorschicht zugeordnet werden.

Gemäß einer weiteren Ausgestaltung der Bedienanordnung sind die Anzeigeelemente des ersten Bedienbereichs dazu ausgestaltet, in Reaktion auf eine Bedienereingabe einen Farbwechsel oder einen Farbverlaufswechsel vorzunehmen. Hierzu können beispielsweise LEDs mit verschiedenen Farben und/oder verschiedenen Filtern kombiniert und selektiv angesteuert werden. Gemäß einer weiteren Ausgestaltung der Bedienanordnung ist der zweite Bedienbereich ferner dazu ausgestaltet, Bedienereingaben, insbesondere Bedienergesten, zu erfassen und in Reaktion auf die Bedienereingaben Informationen darzustellen. Bedienergesten können etwa Eingaben mittels Tippen oder Wischen umfassen.

Gemäß einer weiteren Ausgestaltung der Bedienanordnung ist ferner ein dritter Bedienbereich in das Blendenbauteil integriert, wobei der dritte Bedienbereich vorzugsweise als Bedienbereich für Schnellauswahleingaben ausgestaltet ist. Auch dem dritten Bedienbereich kann auf ein- und derselben Sensorschicht zumindest ein entsprechendes Feld zugeordnet werden.

Gemäß einer weiteren Ausgestaltung der Bedienanordnung ist zumindest einer der Bedienbereiche haptisch hervorgehoben, wobei insbesondere auf der Abdeckschicht eine haptisch wahrnehmbare Hervorhebung ausgebildet ist. Die kann die Bedienerführung weiter verbessern und eine intuitive Bedienung erlauben. Die haptische Hervorhebung führt regelmäßig nicht zu einem Mehraufwand bei der Gestaltung der Sensorschicht.

Gemäß einer weiteren Ausgestaltung der Bedienanordnung umfasst die haptische Hervorhebung eine Vertiefung und/oder eine Erhebung im gekennzeichneten Bedienbereich. Dies kann vorzugsweise bei der Abdeckschicht vorgenommen werden. Gemäß einer weiteren Ausgestaltung der Bedienanordnung ist die haptische Hervorhebung als kreisringartige oder als kreisringabschnittartige Hervorhebung ausgestaltet und einem als Stellregler ausgebildeten Bedienbereich zugeordnet. Auf diese Weise können Stelleingaben und Auswahleingaben einfacher erfolgen. Gestensteuerungen durch Berührungen mittels Fingerspitzen können aufgrund der "Führung" der Finger durch die haptische Hervorhebung vereinfacht werden.

Gemäß einer weiteren Ausgestaltung der Bedienanordnung ist zumindest ein Anzeigeelement, das einem Bedienbereich zugeordnet ist, in verschiedenen Betriebsmodi betreibbar, insbesondere in einem inaktiven Modus, einem aktivierbaren Modus und in einem aktivierten Modus. Beispielhaft ist das zumindest eine Anzeigeelement im inaktiven Modus deaktiviert. Im aktivierbaren Modus kann das zumindest eine Anzeigeelement eine verminderte Helligkeit aufweisen. Im aktivierten Modus kann das zumindest eine Anzeigeelement eine starke Helligkeit aufweisen. Die Betriebsmodi können alternativ oder zusätzlich auch durch definierte Farbzuordnungen gekennzeichnet werden.

Allgemein kann der inaktive Modus als ein Zustand des Anzeigeelements verstanden werden, in dem das diesem zugeordnete Feld nicht für Bedienereingaben nutzbar ist. Dies kann beinhalten, dass eine damit verknüpfte Funktion nicht zur Verfügung steht. Allgemein kann der aktivierbare Modus als ein Zustand des Anzeigeelements verstanden werden, in dem das diesem zugeordnete Feld zumindest potentiell für Bedienereingaben zur Verfügung steht. Allgemein kann der aktivierte Modus als ein Zustand des Anzeigeelements verstanden werden, in dem das diesem zugeordnete Feld durch den Bediener tatsächlich ausgewählt wurde. Die vorgenommene Auswahl kann dem Bediener auf diese Weise angezeigt werden.

Eine Bedienanordnung nach einem der vorgenannten Aspekte kommt bei einem Haushaltsgerät zur Verwendung.

Weitere Merkmale und Vorteile der Erfindung ergeben sich aus der nachfolgenden Beschreibung mehrerer bevorzugter Ausführungsbeispiele unter Bezugnahme auf die Zeichnungen. Es zeigen:
- Fig. 1: eine perspektivische Ansicht eines Haushaltsgerätes mit einer Bedienblende;
- Fig. 2: eine vereinfachte perspektivische Explosionsdarstellung eines Blendenbauteils für eine Bedienblende eines Haushaltsgeräts;
- Fig. 3: eine stark vereinfachte schematische Darstellung eines seitlichen Schnitts durch eine Ausgestaltung eines Blendenbauteils;
- Fig. 4: einen stark vereinfachten schematischen seitlichen Schnitt durch eine weitere Ausgestaltung eines Blendenbauteils;
- Fig. 5: eine schematisch stark vereinfachte Draufsicht auf eine Sensorschicht zur Veranschaulichung möglicher Benutzereingaben beziehungsweise Ben utzergesten;
- Fig. 6: eine weitere schematisch stark vereinfachte Draufsicht auf eine Sensorschicht mit zugewiesenen Feldern, in denen Benutzereingaben zu erfassen sind;
- Fig. 7: eine schematisch stark vereinfachte frontale Ansicht einer Gestaltung eines Blendenbauteils mit visuellen Elementen zur Bedienerführung;
- Fig. 8: eine weitere vereinfachte frontale Ansicht einer alternativen Ausgestaltung eines Blendenbauteils mit visuellen Elementen zur Bedienerführung;
- Fig. 9: noch eine weitere vereinfachte frontale Ansicht einer weiteren alternativen Ausgestaltung eines Blendenbauteils mit visuellen Elementen zur Bedienerführung;
- Fig. 10: eine weitere vereinfachte frontale Ansicht noch einer weiteren Ausgestaltung eines Blendenbauteils mit visuellen Elementen zur Bedienerführung;
- Fig. 11: eine stark vereinfachte frontale Ansicht einer Gestaltung einer Bedienanordnung mit einem Blendenbauteil mit visuellen Elementen zur Bedienerführung;
- Fig. 12: eine schematisch stark vereinfachte frontale Ansicht einer weiteren Bedienanordnung, die der Bedienanordnung gemäß Fig. 11 ähnlich gestaltet ist;
- Fig. 13: eine schematische Blockdarstellung eines Ausführungsbeispiels eines Verfahrens zur Bedienerführung für Bedienereingaben, insbesondere bei einem Haushaltsgerät; und
- Fig. 14: eine schematische Blockdarstellung eines Ausführungsbeispiels eines Verfahrens zur Herstellung eines Blendenbauteils, insbesondere für eine Bedienblende eines Haushaltsgeräts.

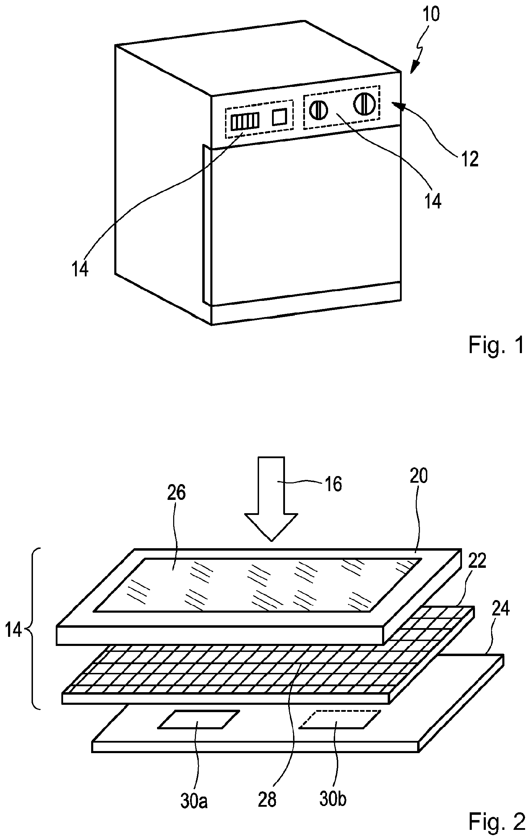

Fig. 1 zeigt eine perspektivische Ansicht eines Haushaltsgeräts 10, das eine Blendenanordnung oder Bedienblende 12 aufweist. Bei dem Haushaltsgerät 10 kann es sich etwa um einen Geschirrspüler oder Ähnliches handeln. Haushaltsgeräte 10 können beispielhaft etwa auch als Waschmaschinen, Kühlschränke, Gefrierschränke, Backöfen, Herde, Mikrowellen, Wäschetrockner oder Ähnliches gestaltet sein. Es sind auch Haushaltsgeräte denkbar, die verschiedene Funktionen in sich vereinen, so etwa Kühl-Gefrier-Kombinationen.

Beispielhaft weist die Bedienblende 12 zumindest ein Blendenbauteil 14 auf. Das zumindest eine Blendenbauteil 14 kann Bereiche umfassen, in denen Elemente zur Bedienung bzw. zur Benutzerinteraktion angeordnet sind. Es versteht sich, dass die Bedienblende 12 insbesondere im Wesentlichen einstückig gestaltet sein kann. Das oder die Blendenbauteile 14 können integrale Bestandteile der Bedienblende 12 sein. Es ist jedoch auch vorstellbar, eine Mehrzahl von Blendenbauteilen 14 als Einzelteile auszuführen und in die Bedienblende 12 zu fügen.

Fig. 2 zeigt eine stark vereinfachte schematische perspektivische Explosionsdarstellung einer beispielhaften Ausgestaltung eines Blendenbauteils 14. Ein mit 16 bezeichneter Pfeil kennzeichnet dabei eine typische Blickrichtung eines Bedieners, der am Blendenbauteil 14 Bedieneingaben vornehmen kann. An seiner dem Bediener zugewandten Seite weist das Blendenbauteil 14 eine Abdeckschicht 20 auf, die insbesondere als Kunststoffbauteil gestaltet sein kann. Aus Sicht des Bedieners "hinter" bzw. "unter" der Abdeckschicht 20 ist eine Sensorschicht 22 angeordnet. Die Sensorschicht 22 kann etwa als Sensorschicht 22 zur Erfassung von Berührungen bzw. Annäherungen ausgebildet sein. Es versteht sich, dass die Sensorschicht 22 in dem anhand der Fig. 2 veranschaulichten Ausführungsbeispiel dazu ausgebildet sein kann, Berührungen oder Annäherungen auf der Ebene der Abdeckschicht 20 zu erfassen, die die Sensorschicht 22 überdecken kann, insbesondere vollständig abdecken kann. Die Sensorschicht 22 kann insbesondere als zumindest abschnittsweise berührempfindliche leitfähige Folie ausgestaltet sein.

An die Sensorschicht 22 kann sich rückwertig, also an der dem Bediener im Normalbetrieb abgewandten Seite des Blendenbauteils 14 eine sogenannte Anzeigeschicht 24 anschließen. Diese kann beispielhaft dazu ausgestaltet sein, bestimmte Bereiche der Sensorschicht 22 für den Bediener zu Zwecken der Bedienerführung und - interaktion visuell hervorzuheben. Gemäß verschiedenen beispielhaften Ausgestaltungen kann die Abdeckschicht 20 zumindest partiell mit transparenten oder transluzenten Bereichen 26 versehen sein. Analog dazu kann auch die Sensorschicht 22 zumindest abschnittsweise transluzent oder transparent gestaltet sein.

Diese Sensorschicht 22 kann ein Sensornetz 28 umfassen und etwa als Folienbauteil gestaltet sein, das verschiedene leitfähige Bereiche aufweist. Die Sensorschicht 22 kann als transparente Folie, alternativ jedoch auch als im Wesentlichen undurchsichtige bzw. opake Folie gestaltet sein. Es versteht sich, dass die Sensorschicht 22 einen Schichtaufbau umfassen kann, beispielsweise verschiedene voneinander isolierte leitfähige Schichten. Die Sensorschicht 22 kann allgemein einen Bereich definieren, in dem Bedienereingaben (Berührungen bzw. Annäherungen) im Bereich der Abdeckschicht 20 erfasst und ausgewertet werden können.

Die Anzeigeschicht (auch: Anzeigeebene) 24 kann zumindest ein diskretes Anzeigeelement 30 umfassen. Beispielhaft weist die anhand der Fig. 2 veranschaulichte Anzeigeschicht 24 ein erstes diskretes Anzeigeelement 30a und ein zweites diskretes Anzeigeelement 30b. Die Anzeigeschicht 24 muss nicht als körperliches Teil vorgesehen sein. Vielmehr kann die Anzeigeschicht 24 zumindest in einigen Ausgestaltungen als (logische) Zusammenfassung verschiedener diskreter Anzeigeelemente 30 aufgefasst werden. Es versteht sich jedoch, dass in alternativen Ausgestaltungen die Anzeigeschicht 24 beispielhaft als Trägerstruktur für das zumindest eine diskrete Anzeigeelement 30 fungieren kann.

Das zumindest eine diskrete Anzeigeelement 30 kann beispielhaft als Piktogramm, Symbol, (vordefinierte) alphanumerische Anzeige, Segmentanzeige, segmentierte Balkenanzeige oder in ähnlicher Weise gestaltet sein. Das zumindest eine diskrete Anzeigeelement 30 soll insbesondere nicht als pixelbasiertes graphisches Anzeigeelement verstanden werden. Vielmehr ist es bevorzugt, wenn das zumindest eine diskrete Anzeigeelement derart vordefiniert und ausgelegt ist, genau eine graphische Information oder eine begrenzte Anzahl verschiedener graphischer Informationen darzustellen. Das zumindest eine diskrete Anzeigeelement kann insbesondere beleuchtbar sein, um eine hinreichende visuelle Hervorhebung für den Bediener zu gewährleisten. Hierzu eignen sich etwa Leuchtdioden, (diskrete) LCD-Elemente oder Ähnliches. Eine begrenzte Variation der durch das zumindest eine diskrete Anzeigeelement 30 darstellbare Information kann etwa durch farbige Hervorhebung erfolgen. Ferner kann, insbesondere bei segmentartigen diskreten Anzeigeelementen 30 durch Ansteuerung verschiedener Segmente/Unterelemente eine Variation der darstellbaren Information erfolgen. Mittels Segmentanzeigen können demgemäß auch alphanumerische Informationen, jedenfalls in begrenztem Umfang, dargestellt werden, wobei die Anzahl anzeigbarer Stellen bzw. Buchstaben vordefiniert und begrenzt ist.

Blendenbauteile 14 gemäß verschiedener Ausgestaltungen der vorliegenden Offenbarung machen sich zunutze, dass die Sensorschicht 22 großflächig bei vertretbarem Kostenaufwand auf die Abdeckschicht 20 appliziert werden kann. Ein Fügen der Abdeckschicht 20 mit der Sensorschicht 22 kann beispielhaft Kleben, Umspritzen, Hinterspritzen, Einbetten, eine kraftschlüssige und/oder formschlüssige Montage sowie weitere geläufige Fügeverfahren umfassen. Auf diese Weise kann das Blendenbauteil 14 in einer Basiskonfiguration, etwa umfassend die Abdeckschicht 20 sowie die Sensorschicht 22, bei vertretbarem Aufwand in Großserie gefertigt werden. Das Blendenbauteil 14 ist insbesondere geeignet für eine selektive Konfektionierung. Dies kann etwa das Zuweisen von Abschnitten bzw. Feldern der Sensorschicht 22 zur Erfassung bestimmter Bedienereingaben umfassen. Mit anderen Worten kann eine vordefinierte Basiskonfiguration durch gezielte Ansteuerung der Sensorschicht bei geringem Aufwand für eine Vielzahl von Variationen hinsichtlich der erlaubten und angebotenen Bedienumfänge herangezogen werden.

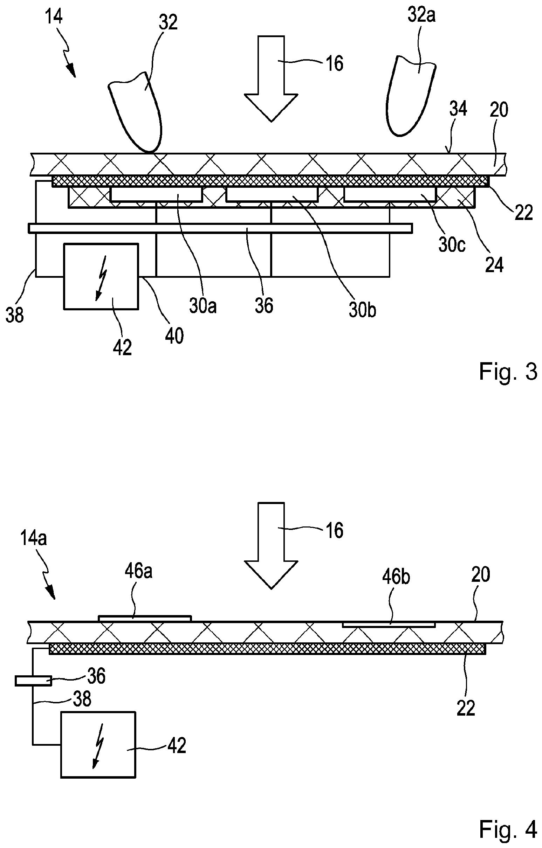

Anhand der Fig. 3 und 4, die jeweils stark vereinfachte schematische Schnitte durch Blendenbauteile 14 zeigen, werden beispielhafte Ausgestaltungen hinsichtlich des Schichtaufbaus der Blendenbauteile 14 veranschaulicht. Fig. 3 zeigt ein Blendenbauteil 14, das etwa im Wesentlichen dem anhand der Fig. 2 veranschaulichten Blendenbauteil 14 entsprechen kann. Das Blendenbauteil 14 gemäß Fig. 3 weist eine Abdeckschicht 20, eine Sensorschicht 22 und eine Anzeigeschicht 24 auf. Die Anzeigeschicht 24 ist mit verschiedenen diskreten Anzeigeelementen 30a, 30b, 30c versehen. Das Blendenbauteil 14 ist mit einer Steuereinrichtung 42 koppelbar, die über eine Schnittstelle 36 und entsprechende Anschlussleitungen 38, 40 mit der Sensorschicht 22 und der Anzeigeschicht 24 kommunizieren kann. Die Steuereinrichtung 42 ist über die Anschlussleitung 38 mit der Sensorschicht 22 verbunden. Über die Anschlussleitung 38 kann die Steuereinrichtung 42 Informationen erfassen, die etwa Berührungen oder Annäherungen an eine Außenfläche 34 der Abdeckschicht 20 beschreiben. Bedienereingaben können mittels eines Aktors 32, 32a vorgenommen werden. Bei dem Aktor 32, 32a kann es sich insbesondere um einen Körperteil des Bedieners handeln, etwa um einen Finger. Es ist jedoch auch vorstellbar, einen Eingabestift (Stylus) oder ähnliches zu verwenden. Die Sensorschicht 22 und die Steuereinrichtung 42 können dazu ausgestaltet sein, Berührungen der Abdeckschicht 20 zu erfassen, vgl. den Finger 32. Alternativ oder zusätzlich können die Sensorschicht 22 sowie die Steuereinrichtung 42 auch dazu ausgestaltet sein, Annäherungen, also keine direkten Berührungen, an die Abdeckschicht 20 zu erfassen, vgl. den Finger 32a.

Die Steuereinrichtung 42 kann ferner über die Anschlussleitung 40 mit den diskreten Anzeigeelementen 30a, 30b, 30c koppelbar sein. Die diskreten Anzeigeelemente 30a, 30b, 30c können selektiv angesteuert bzw. aktiviert werden, um den Bediener anzuleiten bzw. bei einer gewünschten Bedienereingabe zu führen. Insbesondere können die diskreten Anzeigeelemente 30a, 30b, 30c zur visuellen Hervorhebung eines aktuell zugewiesenen und bereitgestellten Unterabschnitts bzw. Feldes aus der Sensorschicht 22 genutzt werden. Auf diese Weise kann die Sensorschicht 22 für eine Vielzahl verschiedener Eingaben genutzt werden und ist in dieser Hinsicht flexibel konfigurierbar.

Es versteht sich, dass sich die diskreten Anzeigeelemente 30a, 30b, 30c in verschiedenen alternativen Ausgestaltungen auch zumindest teilweise überlappen können. Auf diese Weise kann ein und derselbe Bereich der Abdeckschicht 20 je nach Konfiguration der Sensorschicht 22 für verschiedene Eingaben genutzt werden. Beispielhaft kann ein und derselbe Bereich bei einer Waschmaschine zur Auswahl eines Programmodus, zur Temperaturvorwahl sowie zur Zeitsteuerung und für die damit verbundenen erforderlichen Benutzereingaben bzw. Bedienereingaben herangezogen werden. Es versteht sich, dass der dabei jeweils tatsächlich verwendete Abschnitt bzw. das jeweils ausgewählte Feld der Sensorschicht 22 nicht identisch bzw. deckungsgleich sein muss. Vielmehr kann durch logische Ansteuerung der Sensorschicht 22 eine Vielzahl von Abschnitten bzw. Feldern definiert und zur Erfassung und Auswertung von Bedienereingaben herangezogen werden. Die Definition und Zuweisung der Felder kann etwa softwaremäßig und/oder schaltungstechnisch erfolgen.

Fig. 4 zeigt eine alternative Ausgestaltung eines Blendenbauteils 14a. Das Blendenbauteil 14a weist eine Deckschicht 20 sowie eine Sensorschicht 22 auf, die auf der dem Bediener abgewandten Seite der Deckschicht 20 angeordnet bzw. appliziert ist. Die Sensorschicht 22 ist zur Erfassung von Berührungen bzw. Annäherungen ausgestaltet. Zur Ansteuerung bzw. Auswertung von an der Sensorschicht 22 erfassten Eingaben ist das Blendenbauteil 14a mit einer Steuereinrichtung 42 koppelbar, die mittels einer Anschlussleitung 38 über eine Schnittstelle 36 mit der Sensorschicht 22 verbindbar ist. Die Abdeckschicht 20 kann ferner mit zumindest einem Bediensymbol 46 versehen sein. Beispielhaft weist das anhand der Fig. 4 veranschaulichte Blendenbauteil 14 an seiner Abdeckschicht 20 ein erhabenes Bediensymbol 46a und ein versenktes Bediensymbol 46b auf. Allgemein können die Bediensymbole 46 optisch und/oder haptisch wahrnehmbar bei der Abdeckschicht 20 vorgesehen sein.

Zur Erzeugung der Bediensymbole 46 eignen sich etwa Druckverfahren, Verfahren zur Oberflächenbehandlung und/oder Oberflächenbeschichtung, Verfahren zur Abtragung oder Ähnliches. Die Bediensymbole 46 können bei der Formgebung der Abdeckschicht 20, etwa beim Spritzgießen, in diese eingebracht werden. Die Bediensymbole 46 können grundsätzlich farblich hervorgehoben sein. Wie vorstehend bereits dargelegt, kann die Sensorschicht 22 einen potentiell möglichen Bereich definieren, in dem Benutzereingaben erfasst werden können. Die Sensorschicht 22 kann nunmehr derart angesteuert werden, dass bestimmte Abschnitte oder Felder, also Untermengen der Sensorschicht 22, gezielt für bestimmte Benutzereingaben herangezogen und ausgewertet werden. Die jeweils definierten Felder können insbesondere dem jeweiligen Bediensymbol 46a, 46b benachbart oder zugeordnet sein.

Gemäß einer bevorzugten Ausgestaltung kann etwa ein "Halbzeug" des Blendenbauteils 14a gefertigt werden, das eine Basiskonfiguration aufweist. Ein solches "Halbzeug" kann dann zur Variantenbildung genutzt werden, indem verschiedene Bediensymbole 46 darauf gezielt hervorgehoben werden. Dies kann etwa mittels Bedruckung erfolgen. Eine aktuell gewählte Konfiguration der Bediensymbole 46a, 46b kann mit einer zugehörigen logischen Ansteuerung der Sensorschicht 22 verknüpft werden. Auf Basis nur einer Grundkonfiguration kann eine Vielzahl von Varianten realisiert werden, dies kann ohne wesentlichen Mehraufwand bei der Hardware zur Erfassung und Auswertung der Bedienereingaben erfolgen.

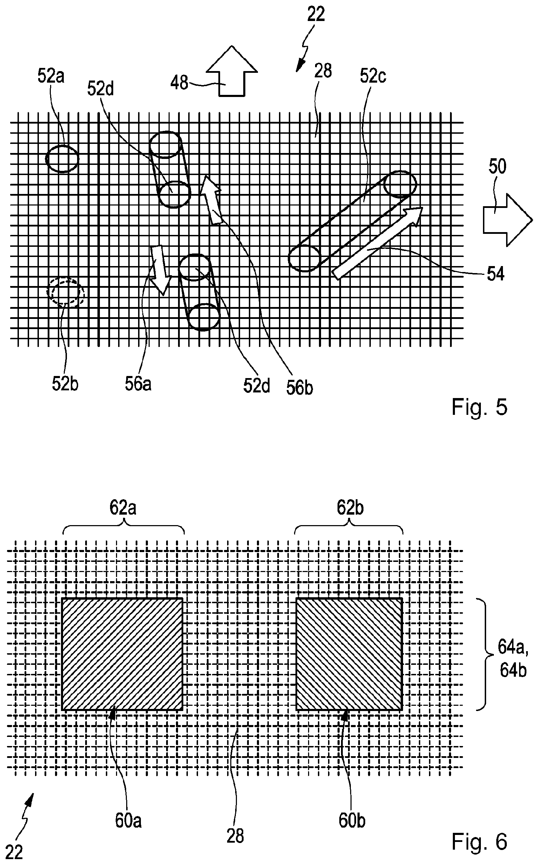

Fig. 5 veranschaulicht eine schematische Draufsicht auf eine beispielhafte Sensorschicht 22. Die Sensorschicht 22 weist ein Sensornetz 28 auf, das etwa eine Spalten und Zeilen umfassende Struktur aufweisen kann. Hierbei kann etwa ein mit 48 bezeichneter Pfeil eine erste Richtung und ein mit 50 bezeichneter Pfeil eine zweite Richtung veranschaulichen. Die Pfeile 48, 50 können beispielhaft eine X-Richtung und eine Y-Richtung darstellen. Die Sensorschicht 22 ist dazu ausgebildet, Bedienereingaben örtlich (also in Bezug auf die erste Richtung 48 und die zweite Richtung 50) zu erfassen. Dies kann etwa bei einer kapazitiven Sensorschicht 22 durch Beeinflussung einer Kapazität aufgrund einer Berührung oder Annäherung erfolgen, die erfasst und ausgewertet wird.

Beispielhaft veranschaulicht Fig. 5 ferner verschiedene denkbare Bedienereingaben bzw. Bedienergesten, die erfassbar und auswertbar sind. Mit 52a ist eine einmalige Antastung (Tip oder Klick) veranschaulicht. Mit 52b ist eine zeitlich aufeinanderfolgende doppelte Antastung veranschaulicht (ein sogenannter Doppel-Klick). Mit 52c ist eine Geste in Form einer Schiebebewegung (ein sogenanntes Wischen) veranschaulicht, vgl. auch die zugehörige Bewegungsrichtung, die durch einen mit 54 bezeichneten Pfeil veranschaulicht ist. Ferner wird durch 52d eine komplexe Geste veranschaulicht, die etwa mit zwei Fingern (bzw. Finger und Daumen) vorgenommen werden kann. Dies kann etwa ein im Wesentlichen gleichzeitiges Antasten mit beiden Fingern und im Anschluss daran ein Auseinanderbewegen der Finger umfassen, vgl. die zugehörigen Richtungsangaben, die durch mit 56a, 56b bezeichnete Pfeile veranschaulicht sind. Eine derartige Geste kann etwa zum Skalieren oder "Zoomen" verwendet werden. Es ist besonders bevorzugt, wenn die Sensorschicht 22 zur gleichzeitigen Erfassung mehrerer Berührungen bzw. Annäherungen ausgebildet ist. Eine solche Funktion kann als Multi-Touch Funktionalität bezeichnet werden.

Fig. 6 veranschaulicht eine logische Untergliederung einer Sensorschicht 22. Wie vorstehend bereits dargelegt, kann die Sensorschicht 22 ein potentiell zur Erfassung von Benutzereingaben nutzbaren Bereich definieren. Innerhalb dieses potentiell möglichen Bereichs können nun etwa Felder 60a, 60b definiert werden, die Untermengen der Sensorschicht 22 darstellen können. Die Zuweisung und Definition der Felder 60a, 60b kann flexibel erfolgen und mit einem geringen (softwaremäßigen oder schaltungstechnischen) Aufwand einhergehen. Ein und derselbe Bereich der Sensorschicht 22 kann (zeitlich beabstandet) für verschiedene Felder 60 genutzt werden, die sich zumindest teilweise überlappen können. Zur örtlichen Erfassung von Bedienereingaben, die im Feld 60a vorgenommen werden, sind insbesondere mit 62a, 64a bezeichnete Bereiche der Sensorschicht 22 auszuwerten. Zur Erfassung von Bedienereingaben, die im Feld 60b vorgenommen werden, ist insbesondere eine Überwachung eines durch 62b, 64b bezeichneten Bereichs der Sensorschicht 22 von Interesse. Die Bereiche 60a, 60b sind flexibel wählbar und können etwa bei der Fertigung softwaremäßig oder schaltungstechnisch in der Steuereinrichtung 42 (vgl. Fig. 3 und Fig. 4) hinterlegt werden.

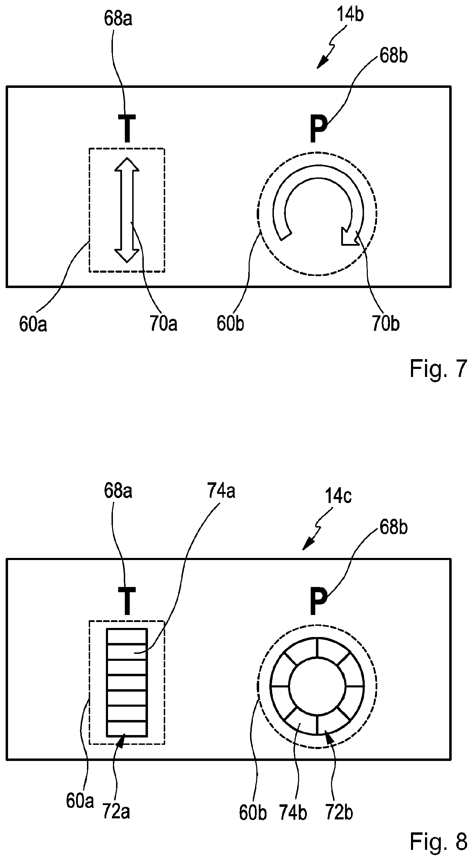

Anhand der Fig. 7, 8, 9 und 10 werden verschiedene weitere beispielhafte Ausgestaltungen von Blendenbauteilen veranschaulicht, die verschiedene diskrete Anzeigeelemente und/oder Bediensymbole zur Bedienerführung aufweisen.

Das Blendenbauteil 14b gemäß Fig. 7 weist Informationsobjekte 68a, 68b auf, die grundsätzlich durch eines der Anzeigeelemente 30 der Anzeigeschicht 24 oder durch eines der Bediensymbole 46 der Abdeckschicht 20 gebildet werden können. Ferner weist das Blendenbauteil 14b diskrete Anzeigeelemente in Form von Piktogrammen 70a, 70b auf. Bei den Piktogrammen 70a, 70b kann es sich beispielhaft etwa um Leuchtanzeigen bzw. Leuchtsymbole handeln. Bei der vorliegenden Konfiguration können Felder 60a, 60b der Sensorschicht 22 (vgl. Fig. 6) derart definiert bzw. gewählt werden, dass sich ein erstes Feld 60a in einem Bereich erstreckt, in dem das Piktogramm 60a angeordnet ist. Ferner kann sich ein Feld 60b in einem Bereich erstrecken, in dem das Piktogramm 70b angeordnet ist. Der Bediener kann nunmehr seine Eingaben direkt über den Piktogrammen 70a, 70b vornehmen, die ihm darüber hinaus ferner auch die gewünschte Art der Eingabe anzeigen können.

Beispielhaft kann der Bediener im Feld 60a eine Wischbewegung oder Schiebebewegung vornehmen, die sich am Piktogramm 70a orientiert, das einen Doppelpfeil darstellt. Auf diese Weise kann der Bediener etwa eine Temperatur wählen. Das Piktogramm 70b veranschaulicht einen kreisförmigen Pfeil. Auf diese Weise kann dem Bediener angezeigt werden, dass er mittels einer Wischbewegung entlang einer Kreisbahn etwa ein Programm wählen kann. Das anhand der Fig. 7 veranschaulichte Ausführungsbeispiel kann mit einer weiteren (nicht dargestellten) Anzeige gekoppelt werden, um dem Bediener eine Rückmeldung hinsichtlich seiner Eingabe zu geben.

Fig. 8 veranschaulicht eine weitere beispielhafte Ausgestaltung eines Blendenbauteils 14c. Das Blendenbauteil 14c ist beispielhaft mit Informationsobjekten 68a, 68b versehen, die etwa als bedruckter oder in ähnlicher Weise gestaltete Bediensymbole ausgestaltet sein können. Ferner weist das Blendenbauteil 14c Anzeigeelemente in Form von Segmentanzeigen 72a, 72b auf, die (logisch) mit definierten Feldern 60a, 60b der Sensorschicht 22 (vgl. Fig. 6) verknüpft sind. Jede der Segmentanzeigen 72a, 72b kann aus einer Mehrzahl von selektiv aktivierbaren Segmenten 74a, 74b gebildet sein. Die Segmentanzeigen 72a, 72b und die diesen zugeordneten Felder 60a, 60b können derart miteinander verknüpft werden, dass ein Benutzer eine Eingabe direkt auf der jeweiligen Anzeige vornehmen kann. Mit anderen Worten kann der Bediener etwa eines der Segmente 74a, 74b durch entsprechende Berührung oder eine ähnliche Geste aktivieren. Eine Rückmeldung an den Bediener kann ohne wesentlichen Zeitverzug durch Aktivieren oder Deaktivieren des entsprechenden Segments 74a, 74b erfolgen.

Die Segmentanzeige 72a kann etwa als Balkenanzeige fungieren. Die Balkenanzeige kann etwa ein Temperaturniveau veranschaulichen. Der Bediener kann durch Antasten oder "Wischen" ein gewünschtes Temperaturniveau wählen, welches ihm unmittelbar durch eine entsprechende Aktivierung der Segmente 74a der Segmentanzeige 72a rückgemeldet wird. In ähnlicher Weise kann der Bediener bei der Segmentanzeige 72b durch Wahl eines der Segmente 74b etwa ein gewünschtes Programm wählen. Dies kann ihm unmittelbar nach seiner Wahl durch visuelle Hervorhebung des gewählten oder abgewählten Segments 74b veranschaulicht werden.

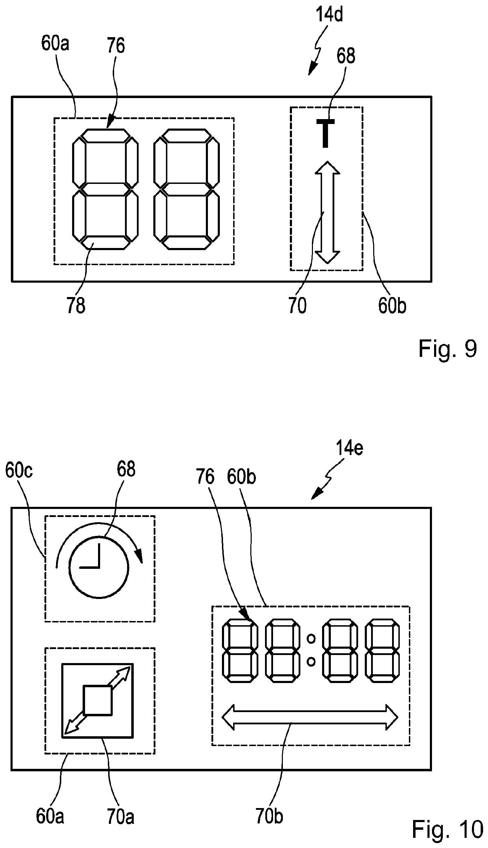

Fig. 9 zeigt eine weitere alternative Ausgestaltung eines Blendenbauteils 14d. Auch das Blendenbauteil 14d kann Bediensymbole aufweisen, die an der zugehörigen Abdeckschicht (vgl. Fig. 4) visuell und/oder haptisch wahrnehmbar sind. Hierbei kann es sich etwa um eine Bedruckung 68 handeln. Die Bedruckung 68 kann beispielhaft ein verknüpftes Feld 60b kennzeichnen, das sich im Bereich eines Piktogramms befindet, das beispielhaft als Leuchtsymbol 72 gestaltet ist. Gemeinsam können die Bedruckung 68 und das Leuchtsymbol 70 den Bediener bei seiner Eingabe anleiten. Es versteht sich, dass ein gewähltes (Bedien-)Feld 60 grundsätzlich auch lediglich mit einem passiven Bediensymbol, etwa einer passiven Bedruckung oder Ähnlichem verknüpft sein kann, ohne dass dem (Bedien-)Feld 60 ein (aktives) Anzeigeelement zugeordnet ist. Eine entsprechende Bedruckung kann etwa ein Symbol sowie eine Kennzeichnung des Bereichs umfassen, in dem der Benutzer seine Eingaben machen kann bzw. seine Auswahl vornehmen kann.

Ferner weist das Blendenbauteil 14d eine Segmentanzeige 76 auf, die insbesondere als 7-Segment-Anzeige gestaltet ist. Die Segmentanzeige 76 weist eine Mehrzahl von Segmenten 78 auf. Der 7-Segment-Anzeige 76 ist ein entsprechendes Feld 60a für Bedienereingaben zugeordnet. So ist es vorstellbar, dass der Bediener im Feld 60a Eingaben direkt an der Anzeige 76 vornehmen kann, etwa durch selektives Aktivieren oder Deaktivieren eines der Segmente 78. Ferner ist vorstellbar, dass die Segmentanzeige 76 zur Rückmeldung an den Bediener genutzt wird, wenn dieser etwa im Feld 60b Eingaben über dem Piktogramm 70 vornimmt.

Fig. 10 veranschaulicht eine weitere Ausgestaltung eines Blendenbauteils 14e, das verschiedene Anzeigeelemente und Bediensymbole zur Bedienerführung aufweisen kann. Beispielsweise ist ein Bediensymbol in Form einer Bedruckung 68, darstellend eine Uhr, vorgesehen. Auf diese Weise wird dem Bediener mitgeteilt, dass am Blendenbauteil 14e eine Zeitdauer oder Uhrzeit einstellbar ist. Dies kann beispielsweise in einem Feld 60b erfolgen, das in der Sensorschicht 22 definiert ist. Das Feld 60b kann beispielhaft einer 7-Segment-Anzeige 76 zugeordnet sein. Das Feld 60b kann ferner ein Piktogramm oder Leuchtsymbol 70b überdecken, an dem der Bediener seine Eingaben vornehmen kann. Eine Rückmeldung kann unmittelbar über die 7-Segment-Anzeige 76 erfolgen.

Das Blendenbauteil 14e weist ferner ein Feld 60a auf, das über einem Piktogramm 70a angeordnet ist. Das Piktogramm 70a kann dem Bediener beispielhaft anzeigen, dass er im Feld 60a Eingaben vornehmen kann, um eine Skalierung bzw. eine Anpassung der Eingabeempfindlichkeit im Feld 60b vorzunehmen. Mit anderen Worten kann der Bediener etwa im Feld 60a mittels einer "Zoom-Geste" die Empfindlichkeit für Zeiteingaben herabsetzen oder erhöhen. Auf diese Weise kann einerseits ein schnelles Durchschreiten des möglichen Wertebereichs ermöglicht werden. Andererseits kann dort, wo es erwünscht ist, eine hochgenaue Eingabe erfolgen. Es wäre grundsätzlich auch vorstellbar, ein Eingabefeld 60c unmittelbar über dem Symbol anzuordnen, das durch die Bedruckung und/oder Oberflächenbearbeitung 68 veranschaulicht wird. Auf diese Weise kann ein Benutzer beispielsweise durch Gesten, die er unmittelbar auf dem Symbol (hier etwa auf der Darstellung einer Uhr) vornimmt, eine entsprechende Eingabe tätigen.

Es versteht sich, dass die aktiven Objekte 70, 72 und 76, die anhand der Fig. 7 bis 10 veranschaulicht werden, als Anzeigeelemente in der Anzeigeschicht 24 angeordnet sein können. Diese Elemente können selektiv aktiviert werden und auf diese Weise visuell durch die Sensorschicht 22 und die Abdeckschicht 20 hindurch durch den Bediener wahrgenommen werden.

Es versteht sich ferner, dass die anhand der in den Fig. 7 bis 10 gezeigten Bespielkonfigurationen veranschaulichten Aspekte und Ausgestaltungen in beliebiger Weise miteinander kombiniert werden können, um dem Bediener in einfacher Weise bei geringem Herstellungssaufwand eine Vielzahl verschiedener Eingabemöglichkeiten bereitstellen zu können. Dies erfolgt grundsätzlich bei hoher Variantenvielfalt. Ein wesentlicher Vorteil ist die freie Skalierbarkeit und Zuordenbarkeit der gewählten (Bedien-)Felder 60 in dem Bereich, der durch die Sensorschicht 22 grundsätzlich zur Verfügung gestellt wird.

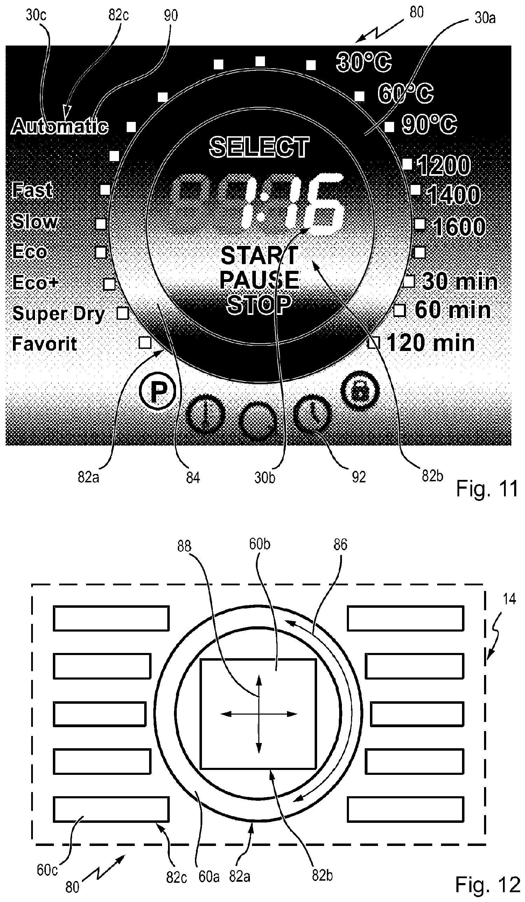

Fig. 11 und Fig. 12 veranschaulichen eine vorteilhafte beispielhafte Ausgestaltung einer Bedienanordnung 80, die von verschiedenen Aspekten der vorliegenden Offenbarung Gebrauch macht. Die Darstellung gemäß Fig. 11 veranschaulicht ein beispielhaftes Layout einer Bedienanordnung 80 für eine Waschmaschine oder ein ähnliches Haushaltsgerät. Die Darstellung gemäß Fig. 12 basiert auf dem anhand der Fig. 11 veranschaulichten Layout. Fig. 12 veranschaulicht jedoch die der Gestaltung gemäß Fig. 11 zugrunde liegenden Prinzipien in abstrahierter Form.

Die Gestaltung der Bedienanordnung 80 gemäß Fig. 11 soll daher im Folgenden lediglich als vorteilhafte Ausgestaltung näher erläutert werden, wobei verschiedene bevorzugte Aspekte dieser Ausgestaltung auch bei Bedienanordnungen 80 mit anderer Funktion und/oder anderem Layout genutzt werden können.

Vorzugsweise beansprucht die Bedienanordnung 80 lediglich eine Bedienblende 12 bzw. lediglich ein Blendenbauteil 14, die von verschiedenen Aspekten der vorliegenden Offenbarung Gebrauch machen können. Mit anderen Worten kann die Bedienanordnung 80 als integrierte Bedienanordnung bezeichnet werden. Dies hat im Wesentlichen den Vorteil, dass mit lediglich einem Bauteil bzw. einem Bauteilkomplex eine erweiterte Bedienerfunktionalität bzw. Anzeigefunktionalität bereitgestellt werden kann. Es ist nicht erforderlich, separate Anzeigeelemente, Bedienelemente und dgl. zu einem "gebauten" Blendenbauteil 14 zu fügen. Insbesondere die Eingabefunktionalität bedarf grundsätzlich lediglich einer Sensorschicht (vgl. etwa auch Fig. 2), um eine Vielzahl verschiedener Bedienereingaben erfassen und auswerten zu können.

Die anhand der Fig. 11 und 12 veranschaulichten Bedienanordnungen 80 umfassen jeweils mehrere Bedienbereiche 82. Beispielhaft umfassen die Bedienanordnungen einen ersten Bedienbereich 82a, einen zweiten Bedienbereich 82b sowie einen dritten Bedienbereich 82c. Jedem der Bedienbereiche 82 kann zumindest ein Feld 60 zur Erfassung von Bedienereingaben zugeordnet sein. Es versteht sich, dass zumindest einem der Bedienbereiche 82 eine Mehrzahl von Feldern 60 zugeordnet sein kann. Lediglich beispielhaft veranschaulicht Fig. 12, dass dem ersten Bedienbereich 82a ein Feld 60a, dem zweiten Bedienbereich 82b ein Feld 60b sowie dem dritten Bedienbereich 82c ein Feld 60c zugeordnet ist. Die Felder 60 können als entsprechende Zuweisungen auf der Sensorschicht 22 zur Erfassung von Bedienereingaben verstanden werden. Die Felder 60 können also eine definierte Untermenge der Sensorschicht 22 darstellen.

Jeder der Bedienbereiche 22 kann zumindest ein optisches Anzeigeelement 30 zur optischen Hervorhebung und/oder Benutzerführung aufweisen. Es ist jedoch ferner bevorzugt, dass zumindest einer der Bedienbereiche 82 mit Elementen zur haptischen Wahrnehmung bzw. zur haptischen Hervorhebung versehen ist. Ein Beispiel einer haptischen Hervorhebung 84 in Reliefform ist in Fig. 11 in Draufsicht angedeutet. Die haptische Hervorhebung 84 ist dem ersten Bedienbereich 82a zugeordnet. Die haptische Hervorhebung 84 kann etwa als ringförmige oder ringabschnittsförmige Erhebung oder Vertiefung ausgebildet sein, die der flächigen Erstreckung des ersten Bedienbereichs 82a zugeordnet ist. Mit anderen Worten kann die haptische Hervorhebung 84 reliefartig etwa als kreisförmig umlaufende Rille ausgestaltet sein und die Abmessungen des ersten Bedienbereichs 82a haptisch wahrnehmbar kennzeichnen. Mit anderen Worten kann der Bediener etwa mit seiner Fingerspitze die haptische Hervorhebung 84 "erfühlen" und wird bei seiner Eingabe haptisch durch die Hervorhebung 84 geleitet, etwa auf einer Ringbahn bzw. Ringabschnittsbahn. Es versteht sich, dass der erste Bedienbereich 82a zusätzlich visuell gekennzeichnet sein kann, um den Benutzer zu leiten bzw. um dem Benutzer seine Eingabe anzuzeigen. Zu diesem Zweck kann auf das zumindest Anzeigeelement 30a zurückgegriffen werden, das dem ersten Bedienbereich 82a zugeordnet ist.

Grundsätzlich können die Bedienbereiche 82a, 82b, 82c des anhand der Fig. 11 und 12 veranschaulichten Layouts in geeigneter Weise zusammenwirken, um dem Benutzer einerseits eine schnelle und intuitive Bedienung zu ermöglichen und andererseits eine Vielzahl von Eingabemöglichkeiten bereitzustellen.

Beispielhaft kann der erste Bedienbereich 82a etwa als sog. Drehregler gestaltet sein. Zu diesem Zweck kann ein ringförmiges oder ringabschnittsförmiges Feld 60a (vgl. Fig. 12) dem Bedienbereich 82a zugewiesen werden. Folglich kann eine der Bedienanordnung 80 zugeordnete Steuereinrichtung 42 (vgl. etwa Fig. 3 und Fig. 4) in bestimmter Weise angesteuert werden, um Bedienereingaben im ersten Bedienbereich 82a zu erfassen. Der Bediener kann also etwa durch Antippen oder Wischen auf dem Kreisring oder Kreisringabschnitt, der durch die erste Bedienanordnung 80a bereitgestellt wird, Eingaben tätigen. Diese Eingaben können etwa die Auswahl von Prozessgrößen umfassen, insbesondere die Auswahl bestimmter Werte aus relativ großen Wertebereichen. Beispielhaft kann der Benutzer am ersten Bedienbereich 82a etwa durch Wischen oder Antippen eine Temperaturauswahl, eine Zeitauswahl, eine Drehzahlauswahl oder ähnliche Eingaben tätigen.

Insbesondere ein Wischen entlang einer Kreisbahn (vgl. einen mit 86 bezeichneten gekrümmten Doppelpfeil in Fig. 12) kann eine schnelle und präzise Eingabe erlauben. Der erste Bedienbereich 82a ist mit zumindest einem Anzeigeelement 30a verknüpft. Vorzugsweise ist beim ersten Bedienbereich 82a eine ebenso kreisförmige oder ringförmige Anordnung von Anzeigeelementen 30 vorgesehen. Es kann sich dabei etwa um Leuchtdioden (LEDs) und ähnliche Anzeigeelemente handeln. Demgemäß kann der erste Bedienbereich 82a etwa ähnlich einem Kreisdiagramm oder Tortendiagramm zur Veranschaulichung eines aktuell gewählten Wertes innerhalb eines Wertebereichs mit bestimmten Grenzen genutzt werden. Dies kann dem Benutzer bereits während seiner Eingabe unmittelbar angezeigt werden. Vorzugsweise kann also die Beeinflussung des Wertes bzw. des Kreisdiagramms direkt durch Antippen oder Wischen erfolgen, wobei zugeordnete Anzeigeelemente 30 direkt am aktuellen Berührpunkt selektiv angesteuert werden können, um ein "Feedback" zu geben.

Gemäß einer Ausgestaltung sind die dem ersten Bedienbereich 82a zugeordneten Bedienelemente 30 dazu ausgestaltet, Informationen in verschiedenen Farben darzustellen. Demgemäß können etwa verschiedene Leuchtdioden bzw. Leuchtdioden mit verschiedenen Filtern genutzt werden, um verschiedene Farben darzustellen. Ferner können Mischfarben durch gezielte Ansteuerung verschiedenfarbiger Leuchtdioden zumindest angenähert erzeugt werden. Es wäre auch vorstellbar, sog. RGB-LEDs zu verwenden und gezielt anzusteuern, um verschiedene Farben darzustellen.

Die Fähigkeit zur Hervorhebung bestimmter Abschnitte des ersten Bedienbereichs 82a in verschiedenen Farben kann in vorteilhafter Weise ausgenutzt werden. Beispielhaft kann dem Benutzer bei der Temperaturvorwahl mittels bekannter Assoziationen (etwa kalt: Blau sowie heiß: Rot) eine visuelle Unterstützung für seine Eingabe bereitgestellt werden. Es wäre jedoch auch vorstellbar, energetische Auswirkungen von Nutzereingaben durch gezielte farbliche Hervorhebung zu kennzeichnen. Besonders energiesparende Eingaben (bzw. gewählte Programm/Betriebsparameter) könnten beispielsweise durch grüne Hervorhebungen gekennzeichnet werden. Energieintensive Eingaben (bzw. gewählte Programm/Betriebsparameter) könnten demgemäß etwa durch rote Hervorhebungen gekennzeichnet werden. Am ersten Bedienbereich 82a selbst kann demgemäß etwa ein Farbverlauf dargestellt werden (etwa von Rot zu Grün oder von Rot zu Blau), wobei dem Bediener ferner angezeigt werden kann, an welchem Punkt des Farbverlaufs bzw. bei welchem Wert des dem Verlauf zugrunde liegenden Wertebereichs er sich aktuell befindet.

Der erste Bedienbereich 82a kann ferner zur Veranschaulichung einer Restlaufzeit, eines Countdowns (etwa bis zum Start eines vorgewählten Programms) und in ähnlicher Weise genutzt werden. Beispielhaft könnte im ersten Bedienbereich 82a auch ein Füllstand (Waschmittelvorrat, ein Weichspülervorrat oder ein Vorrat eines Entkalkungsmittels) angezeigt werden. Auch ein aktueller Programmfortschritt kann über dem ersten Bedienbereich 82a zugeordnete Anzeigeelemente 30 angezeigt werden.

Bei dem zweiten Bedienbereich 82b handelt es sich beispielhaft bei den Fig. 11 und 12 um einen Bereich, der vom ersten Bedienbereich 82a begrenzt bzw. umschlossen ist. Grundsätzlich kann der zweite Bedienbereich 82b zumindest ein zugeordnetes Feld 60b zur Erfassung von Benutzereingaben umfassen. Dem zweiten Bedienbereich 82b kann zumindest ein entsprechendes Anzeigeelement 30b zugeordnet sein. Das zumindest eine Anzeigeelement 30b für den zweiten Bedienbereich 82b kann beispielhaft eine Segmentanzeige, insbesondere eine 7-Segment-Anzeige, umfassen. Ferner kann der zweite Bedienbereich 82b Anzeigeelemente 30 umfassen, die als diskrete Anzeigeelemente, Piktogramme oder in ähnlicher Weise gestaltet sind und vorzugsweise optisch aktivierbar sind. Eine optische Aktivierung kann etwa eine Hinterleuchtung umfassen. Grundsätzlich kann der zweite Bedienbereich 82b dazu ausgestaltet sein, Informationen darzustellen, die etwa einen Wert wiedergeben, den der Benutzer im ersten Bedienbereich 82a ausgewählt hat. Die Darstellung kann insbesondere eine numerische oder alphanumerische Darstellung umfassen. Zu diesem Zweck kann auf die Segmentanzeige zurückgegriffen werden. Mit anderen Worten kann im zweiten Bedienbereich 82b etwa eine gewählte Temperatur, eine gewählte Zeit oder Zeitdauer und/oder ein gewähltes Programm angezeigt werden.

Ferner können im zweiten Bedienbereich 82b etwa grundlegende Statusinformationen dargestellt werden. Dies kann insbesondere eine grundlegende Programmfunktionalität umfassen, wie etwa START, STOP, PAUSE und dgl.

Ferner ist es bevorzugt, wenn der zweite Bedienbereich 82b auch dazu ausgestaltet ist, Benutzereingaben zu erfassen. Mit anderen Worten kann auch das dem zweiten Bedienbereich 82b zugewiesene Feld 60b zur Erfassung von Bedienereingaben überwacht und ausgewertet werden. Beispielhaft können Bedienereingaben im Feld 60b durch Antippen oder Wischen vorgenommen werden, vgl. etwa mit 88 bezeichnete Doppelpfeile in Fig. 12. Auch auf diese Weise kann der Bediener Werte aus Wertebereichen auswählen. Es ist jedoch auch vorstellbar, im zweiten Bedienbereich 82b Direkteingaben vorzunehmen.

Gemäß einer weiteren Ausgestaltung kann im zweiten Bedienbereich 82b eine grafikfähige Anzeige vorgesehen sein. Demgemäß kann der zweite Bedienbereich 82b zur Anzeige von pixelbasierten Grafiken ausgestaltet sein. Ein entsprechendes Display kann etwa als LCD-Display, TFT-Display, OLED-Display oder in ähnlicher Weise ausgestaltet sein. Auch ein derartiges Display kann mit der Sensorschicht 22 kombiniert werden, um in dem dem zweiten Bedienbereich 82b zugeordneten Feld 60b Bedienereingaben zu erfassen und um in Reaktion auf die Bedienereingaben Informationen im zweiten Bedienbereich 82b darzustellen.

Ferner kann die Bedienanordnung 80 einen dritten Bedienbereich 82c umfassen. Der dritte Bedienbereich 82c kann mit zumindest einem entsprechenden Feld 60c für Bedienereingaben gekoppelt sein. Vorzugsweise weist der dritte Bedienbereich 82c mehrere Felder 60 für Bedienereingaben auf. Beispielhaft kann der dritte Bedienbereich 82c verschiedene Schnellauswahlfunktionen umfassen, die etwa durch Antippen oder Annäherungen ausgewählt oder abgewählt werden können. Demgemäß kann jedes dem dritten Bedienbereich 82c zugeordnete Feld 60 zumindest ein Anzeigeelement 30c umfassen, das selektiv aktivierbar ist. Das Anzeigeelement 30c kann etwa ein Piktogramm oder eine vordefinierte alphanumerische Darstellung umfassen, die selektiv aktivierbar ist, insbesondere beleuchtbar ist. Der Bediener kann durch gezieltes Antippen des gewünschten Feldes 60c des dritten Bedienbereichs 82c eine Schnellauswahl vornehmen. In Reaktion auf die Auswahl des Bedieners kann das zugehörige Anzeigeelement 30c aktiviert werden, um dem Bediener eine visuelle Rückmeldung geben zu können. Beispielhaft kann der dritte Bedienbereich 82c häufig gewählte Funktionen umfassen, die besonders schnell direkt angewählt werden können. Auf diese Weise kann die Bedienung des Haushaltsgeräts 10 weiter vereinfacht werden.

In Fig. 11 ist eine denkbare alphanumerische Information, die dem Bediener im dritten Bedienbereich 82c dargestellt werden kann, mit 90 bezeichnet. Ein beispielhaftes Piktogramm, das dem Bediener im dritten Bedienbereich 82c dargestellt werden kann, ist mit 92 bezeichnet.

Es ist besonders bevorzugt, wenn zumindest einige der Anzeigeelemente 30a, 30b, 30c der Bedienanordnung 80 in verschiedenen Betriebsmodi betreibbar sind. Dies kann die Benutzerführung vereinfachen und dem Bediener die Bedienung erleichtern. Denkbare Betriebsmodi können etwa einen inaktiven Modus, einen aktivierbaren Modus und einen aktivierten Modus umfassen. Zumindest einige der Betriebsmodi können visuell hervorgehoben sein. Unter einem inaktiven Modus soll ein Modus verstanden werden, in dem im aktuell mit dem Anzeigeelement 30 verknüpften Feld 30 keine Eingaben ermöglicht sind. Vorzugsweise ist dann das entsprechende Anzeigeelement 30 "optisch" deaktiviert oder zumindest ausgeblendet. Dies kann auch durch Zuweisung einer bestimmten Farbe erfolgen. Auf diese Weise kann dem Bediener unmittelbar mitgeteilt werden, dass das aktuelle Feld 60 nicht für Eingaben oder Auswahlvorgänge zur Verfügung steht.

Im aktivierbaren Modus des Anzeigeelements 30 steht das mit diesem verknüpfte Feld 60 aktuell für Eingaben zur Verfügung. Auf diese Weise kann dem Bediener angezeigt werden, dass er grundsätzlich eine Auswahl treffen kann oder sollte. Der aktivierbare Modus kann etwa durch eine Hervorhebung mit verminderter Helligkeit des Anzeigeelements oder mit einer bestimmten dem aktivierbaren Modus zugeordneten Farbe gekennzeichnet werden. Der aktivierte Modus des Anzeigeelements 30 kann anzeigen, dass das mit dem Anzeigeelement 30 verknüpfte Feld 60 durch den Bediener ausgewählt wurde. Vorzugsweise weist das Anzeigeelement 30 im aktivierten Modus eine hohe Helligkeit bzw. einen hohen Kontrast zu seiner Umgebung auf. Es ist auch vorstellbar, das Anzeigeelement 30 im aktivierten Modus in einer bestimmten Farbe hervorzuheben.

Die vorgeschriebenen Modi eignen sich insbesondere für den dritten Bedienbereich 82c, der verschiedene Schnellauswahlmöglichkeiten umfassen kann, können jedoch grundsätzlich bei den im Rahmen dieser Offenbarung beschriebenen Anzeigeelementen genutzt werden.

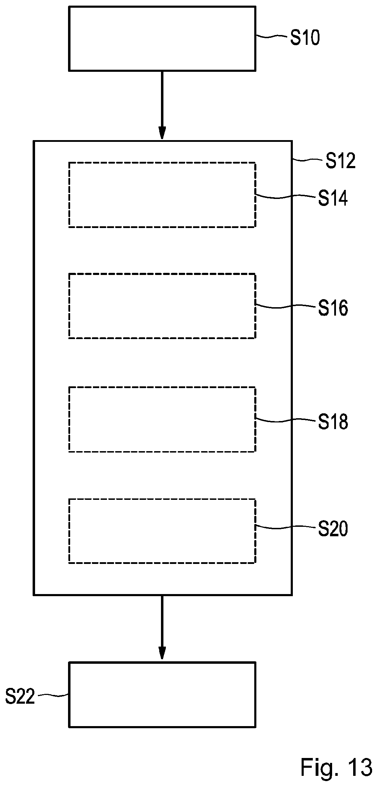

Fig. 13 veranschaulicht in vereinfachter Weise ein Ausführungsbeispiel eines Verfahrens zur Bedienerführung, etwa für Bedienereingaben bei einem Haushaltsgerät. Dies kann in vorteilhafter Weise mit einem Blendenbauteil 14 und einer damit versehenen Bedienblende 12 erfolgen, die gemäß verschiedenen der vorstehend genannten und beschriebenen Aspekte ausgestaltet sind. In einem Schritt S10 wird ein Blendenbauteil bereitgestellt, das eine von einer Abdeckschicht verdeckte Sensorschicht umfasst, die dazu ausgebildet ist, Bedienereingaben und insbesondere Bedienergesten zu erfassen.

In einem weiteren nachgelagerten Schritt wird ein aktueller Eingabemodus definiert. Der Schritt S12 kann insbesondere einen (Teil-)Schritt S14 umfassen, in dem ein Feld, das etwa einen Abschnitt oder eine Teilmenge der Sensorschicht umfasst, definiert und zur Auswertung zugewiesen wird. Dies kann ferner mit einem (Teil-)Schritt S16 verknüpft werden, der das Aktivieren zumindest eines diskreten Anzeigeelements umfasst, um dem Bediener das aktuell aktivierte Feld für seine Eingaben visuell zu veranschaulichen. Alternativ oder zusätzlich kann beim Schritt S12 ein (Teil-)Schritt S18 vorgesehen sein, der das Zuordnen eines gewählten (Bedien-)Feldes zu einem Bediensymbol umfasst, das an der Abdeckschicht des Blendenbauteils vorgesehen ist. Bei dem Bediensymbol kann es sich etwa um ein gedrucktes Bediensymbol oder Ähnliches handeln. Dem Bediensymbol kann (softwaremäßig oder schaltungstechnisch) ein Feld zugeordnet werden, das im Bereich der Sensorschicht grundsätzlich frei wählbar ist.

Der Schritt S12 kann ferner einen optionalen (Teil-)Schritt S20 umfassen, der eine Ausgabe einer Rückmeldung an den Bediener umfasst. Zu diesem Zweck kann zumindest ein diskretes Anzeigeelement angesteuert bzw. aktiviert werden. Auf diese Weise kann dem Bediener seine Eingabe unmittelbar visuell kenntlich gemacht werden. Insbesondere ist es bevorzugt, wenn das zumindest eine Anzeigeelement im Bereich des aktuell zugewiesenen Feldes für Bedienereingaben angeordnet ist. So kann sich dem Bediener der Eindruck ergeben, seine Eingaben "direkt" am Anzeigeelement vorzunehmen. An den Schritt S12 kann sich ein Schritt S22 anschließen, der das Erfassen und Auswerten der Bedienereingaben im aktuell definierten und auszuwertenden Feld umfasst.

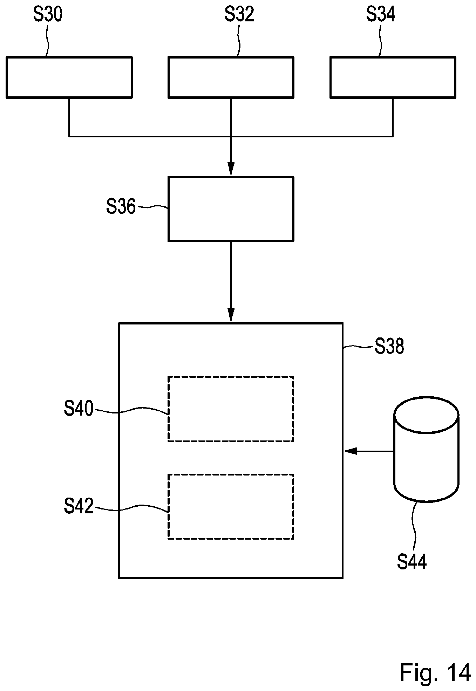

Fig. 14 veranschaulicht in vereinfachter Weise ein Ausführungsbeispiel eines Verfahrens zur Erzeugung bzw. Herstellung eines Blendenbauteils, insbesondere für eine Bedienblende eines Haushaltsgeräts. Das Verfahren kann Schritte S30, S32 und S34 umfassen. Der Schritt S30 umfasst die Bereitstellung einer Abdeckschicht, insbesondere einer Abdeckschicht aus einem Kunststoffwerkstoff. Der Schritt S32 umfasst die Bereitstellung einer abschnittsweise aktivierbaren Sensorschicht, insbesondere einer sich flächig erstreckenden Sensorschicht, die dazu ausgebildet ist, Bedienereingaben, insbesondere Bedienergesten, zu erfassen. Der Schritt S34 umfasst die Bereitstellung einer Anzeigeschicht, die zumindest ein diskretes Anzeigeelement umfasst, das selektiv aktivierbar ist.

Den Schritten S30, S32 und S34 kann sich ein Schritt S36 anschließen, der das Fügen der Abdeckschicht, der Sensorschicht und der Anzeigeschicht umfasst. Hierbei kann die Sensorschicht auf einer (im Normalbetrieb) dem Bediener abgewandten Seite der Abdeckschicht angeordnet werden. Auf der dem Bediener abgewandten Seite der Sensorschicht kann die Anzeigeschicht mit dem zumindest einen diskreten Anzeigeelement angeordnet werden.

Es kann sich ein Schritt S38 anschließen, der eine Zuweisung zumindest eines definierten Feldes auf der Sensorschicht in Abhängigkeit von einem gewünschten Eingabemodus umfasst. Beispielhaft können Felder auf der Sensorschicht 22 ausgewählt und definiert werden, die zumindest einem diskreten Anzeigeelement zugeordnet sind. Ferner können jedoch auch Felder gewählt werden, die Bediensymbolen oder ähnlichen optisch und/oder haptisch wahrnehmbaren Symbolen zugeordnet sind, die bei der Abdeckschicht vorgesehen sind. Der Schritt S38 kann besonders flexibel erfolgen, um eine Vielzahl von Varianten auf Basis einer gegebenen Sensorschicht zu realisieren.

Der Schritt S38 kann einen Schritt S40 umfassen, der die Bereitstellung einer Schnittstelle zur Ansteuerung der Sensorschicht und, sofern erforderlich, zur Ansteuerung des zumindest einen diskreten Anzeigeelements umfasst. Ferner kann der Schritt S38 die Bereitstellung und Einrichtung eines Steuergeräts umfassen, wie durch einen Schritt S42 veranschaulicht. Ein Steuergerät kann über die Schnittstelle mit dem Verbund aus Abdeckschicht, Sensorschicht und, sofern vorhanden, Anzeigeschicht verknüpft werden. Beim Schritt S38 kann auf eine Datenbasis bzw. Datenbank zurückgegriffen werden, vgl. das Bezugszeichen S44. In der Datenbank kann eine Mehrzahl potentiell möglicher Konfigurationen umfassend jeweilige Eingabemodi abgelegt sein. Unter Verwendung der Datenbank kann beim Schritt S38 eine flexible Zuweisung und Konfiguration eines Systems erfolgen, das das Blendenbauteil sowie das mit diesem über die Schnittstelle verknüpfte Steuergerät bzw. die zugehörige Steuereinrichtung umfasst. Eine Konfiguration der Steuereinrichtung kann softwaremäßig und/oder hardwaremäßig erfolgen.

Insgesamt erlaubt die Sensorschicht, die flächig bei der Abdeckschicht vorgesehen ist, eine freie und flexible Konfiguration für eine Vielzahl verschiedener Bedienereingaben. Die Sensorschicht, sofern vorhanden, kann zur Benutzerführung und zur Interaktion mit dem Benutzer/Bediener herangezogen werden. Dem Bediener kann auch mit vergleichbar einfach gestalteten diskreten Anzeigeelementen bzw. mit an der Abdeckschicht vorgesehenen Bediensymbolen die Möglichkeit zur Vornahme komplexer Bedienereingaben angeboten werden. Dies kann insbesondere ohne aufwändige pixelbasierte Anzeigeelemente erfolgen, so dass die Fertigung mit reduziertem Aufwand erfolgen kann.

## Patentansprüche

1. Verfahren zur selektiven Bedienerführung für Bedienereingaben bei einem Haushaltsgerät (10), umfassend die folgenden Schritte:
- Bereitstellen eines Blendenbauteils (14) mit einer von einer Abdeckschicht (20) verdeckten Sensorschicht (22), die sich flächig erstreckt und die dazu ausgebildet ist, Bedienereingaben in Form von Bedienergesten zu erfassen, wobei die Sensorschicht (22) abschnittsweise aktivierbar ist, wobei das Blendenbauteil (14) eine Basiskonfiguration aufweist und variantenspezifisch ansteuerbar ist,
- Definition eines aktuellen Eingabemodus, umfassend:
- flexibles, softwaremäßiges oder schaltungstechnisches, Zuweisen zumindest eines definierten auszuwertenden Feldes (60), das einem Abschnitt der Sensorschicht (22) entspricht, für Bedienereingaben in Form von Bedienergesten auf der Sensorschicht (22) in Abhängigkeit von dem gewünschten Eingabemodus,
- Aktivieren zumindest eines diskreten Anzeigeelements (30) einer Anzeigeschicht (24), die auf der der Abdeckschicht (20) abgewandten Seite der Sensorschicht (22) angeordnet ist, zur Kennzeichnung des auszuwertenden Feldes (60) der Sensorschicht (22), wobei das zumindest eine diskrete Anzeigeelement (30) ein nicht-pixelbasiertes Anzeigeelement ist, und
- Erfassen und Auswerten von Bedienereingaben im auszuwertenden Feld (60).

2. Verfahren nach Anspruch 1, wobei der Schritt der Definition des aktuellen Eingabemodus ferner den folgenden Schritt umfasst:
- Zuordnen des auszuwertenden Feldes (60) für Bedienereingaben zu einem Bediensymbol (46), das auf der Abdeckschicht (20) optisch und/oder haptisch wahrnehmbar ist.

3. Verfahren nach einem der vorhergehenden Ansprüche, ferner umfassend:
- Ausgeben einer visuellen Rückmeldung an den Bediener in Reaktion auf eine Bedienereingabe durch selektives Aktivieren zumindest eines diskreten, nicht-pixelbasierten Anzeigeelements (30) der Anzeigeschicht (24).

4. Blendenbauteil (14) für eine Bedienblende (12) für ein Haushaltsgerät (10) zum Durchführen eines Verfahrens nach Anspruch 1, wobei das Blendenbauteil (14) Folgendes aufweist:
- eine Abdeckschicht (20),
- eine abschnittsweise aktivierbare Sensorschicht (22), die eine Rückseite der Abdeckschicht (20) zumindest abschnittsweise flächig bedeckt,
- eine Anzeigeschicht (24) mit zumindest einem diskreten Anzeigeelement (30), wobei das zumindest eine diskrete Anzeigeelement (30) ein nicht-pixelbasiertes Anzeigeelement ist,
wobei die Sensorschicht (22) der Abdeckschicht (20) und dem zumindest einen diskreten, nicht-pixelbasierten Anzeigeelement (30) zwischengeordnet ist, wobei das Blendenbauteil (14) eine Basiskonfiguration aufweist und variantenspezifisch ansteuerbar ist,
wobei die Sensorschicht (22) dazu ausgebildet ist, Bedienereingaben in Form von Bedienergesten zu erfassen, wobei die Sensorschicht (22) in Abhängigkeit von einem gewünschten Eingabemodus abschnittsweise aktivierbar ist, wobei für Bedienereingaben auf der Sensorschicht (22) zumindest ein definiertes auszuwertendes Feldes (60), das einem Abschnitt der Sensorschicht (22) entspricht, flexibel, softwaremäßig oder schaltungstechnisch, zuweisbar ist, und
wobei das zumindest eine diskrete, nicht-pixelbasierte Anzeigeelement (30) zur selektiven Bedienerführung ansteuerbar ist.

5. Blendenbauteil (14) nach Anspruch 4, wobei die Sensorschicht (22) als kapazitive Sensorschicht (22) ausgebildet ist und dazu ausgebildet ist, Berührungen auf der Abdeckschicht (20) und/oder Annäherungen an die Abdeckschicht (20) im Bereich der Sensorschicht (22) zu erfassen.

6. Blendenbauteil (14) nach Anspruch 4 oder 5, ferner aufweisend eine Schnittstelle (36) für eine Steuereinrichtung (42), die dazu ausgebildet ist, die Sensorschicht (22) und das zumindest eine diskrete, nicht-pixelbasierte Anzeigeelement (30) selektiv anzusteuern, um eine Mehrzahl von Eingabemodi zu definieren, wobei die Steuereinrichtung (42) dazu ausgebildet ist, einen aktuellen Eingabemodus zu definieren, und, unter Berücksichtigung zumindest eines gewählten Eingabemodus, zumindest ein auszuwertendes Feld (60) für Bedienereingaben auf der Sensorschicht (22) zuzuweisen.

7. Blendenbauteil (14) nach einem der Ansprüche 4 bis 6, umfassend zumindest ein nicht-pixelbasiertes Anzeigeelement (30), das als diskretes, selektiv aktivierbares Symbol (68, 70) oder als diskrete, selektiv aktivierbare Segment-Anzeige (72, 76) ausgebildet ist, insbesondere als Sieben-Segment-Anzeige.

8. Blendenbauteil (14) nach einem der Ansprüche 4 bis 7, wobei die Abdeckschicht (20) und die Sensorschicht (22) zumindest abschnittsweise transparent oder transluzent gestaltet sind, und wobei die Abdeckschicht (20) zumindest abschnittsweise oberflächenbehandelt ist, insbesondere bedruckt oder beschichtet, und wobei die Abdeckschicht (20) zumindest ein optisch und/oder haptisch wahrnehmbares Bediensymbol (46) zur Bedienerführung aufweist.

9. Bedienanordnung (80) für ein Haushaltsgerät (10) mit einem Blendenbauteil (14) nach einem der Ansprüche 4 bis 8, wobei die Bedienanordnung (80) eine Mehrzahl definierter Bedienbereiche (82) umfasst, die insbesondere am Blendenbauteil (14) ausgebildet sind, und wobei jedem Bedienbereich (82) zumindest ein Feld (60) für Bedienereingaben sowie zumindest ein diskretes, nicht-pixelbasiertes Anzeigeelement (30) zugeordnet ist.

10. Bedienanordnung (80) nach Anspruch 9, wobei das Blendenbauteil (14) als integrales Blendenbauteil (14) ausgestaltet ist, in das die Bedienbereiche (82) integriert sind, wobei zumindest ein erster Bedienbereich (82a) und ein zweiter Bedienbereich (82b) vorgesehen sind, wobei der erste Bedienbereich (82a) einen mittels Gesten steuerbaren Stellregler und diskrete, nicht-pixelbasierte Anzeigeelemente (30a) zur visuellen Hervorhebung eines Stellbereichs umfasst, und wobei der zweite Bedienbereich (82b) eine multifunktionale Anzeige mit zumindest einem diskreten, nicht-pixelbasierten Anzeigeelement (30b) umfasst, die zumindest dazu ausgebildet ist, einen am ersten Bedienbereich (82a) gewählten Wert anzuzeigen.

11. Bedienanordnung (80) nach Anspruch 10, wobei die diskreten, nicht-pixelbasierten Anzeigeelemente (30a) des ersten Bedienbereichs (82a) dazu ausgestaltet sind, in Reaktion auf eine Bedienereingabe einen Farbwechsel oder einen Farbverlaufswechsel vorzunehmen, und wobei der zweite Bedienbereich (82b) ferner dazu ausgestaltet ist, Bedienereingaben in Form von Bedienergesten zu erfassen und in Reaktion auf die Bedienereingaben Informationen darzustellen.

12. Bedienanordnung (80) nach einem der Ansprüche 10 oder 11, wobei zumindest einer der Bedienbereiche (82) haptisch hervorgehoben ist, wobei auf der Abdeckschicht (20) eine haptisch wahrnehmbare Hervorhebung (84) ausgebildet ist, und wobei die haptische Hervorhebung (84) vorzugsweise eine Vertiefung und/oder eine Erhebung im gekennzeichneten Bedienbereich (82) umfasst.

13. Verfahren zur Herstellung eines Blendenbauteils (14) einer Bedienblende (12) für ein Haushaltsgerät (10), wobei das Blendenbauteil (14) eine Basiskonfiguration aufweist und variantenspezifisch ansteuerbar ist, wobei das Verfahren die folgenden Schritte aufweist:
Bereitstellung einer Abdeckschicht (20) aus einem Kunststoffwerkstoff,
- Bereitstellung einer sich flächig erstreckenden, abschnittsweise aktivierbaren Sensorschicht (22), die dazu ausgebildet ist, Bedienereingaben in Form von Bedienergesten zu erfassen,
- Bereitstellung zumindest eines diskreten Anzeigeelements (30), wobei das zumindest eine diskrete Anzeigeelement (30) ein nicht-pixelbasiertes Anzeigeelement ist,
- Fügen der Abdeckschicht (20), der Sensorschicht (22) und des zumindest eines diskreten, nicht-pixelbasierten Anzeigeelements (30), wobei die Sensorschicht (22) der Abdeckschicht (20) und dem zumindest einen diskreten, nicht-pixelbasierten Anzeigeelement (30) zwischengeordnet wird, und
- Bereitstellen einer Schnittstelle (36) für eine Steuereinrichtung (42) zur Ansteuerung des zumindest einen diskreten, nicht-pixelbasierten Anzeigeelements (30) und zur Auswertung von an der Sensorschicht (22) erfassten Bedienereingaben zur selektiven Bedienerführung, und
flexibles, softwaremäßiges oder schaltungstechnisches, Zuweisen zumindest eines auszuwertenden Feldes (60), das einem Abschnitt der Sensorschicht (22) entspricht, für Bedienereingaben auf der Sensorschicht (22) in Abhängigkeit von einer gewünschten Eingabekonfiguration des Blendenbauteils (14).

14. Verfahren nach Anspruch 13, ferner aufweisend die folgenden Schritte:
- Bearbeitung der Abdeckschicht (20), insbesondere Bedruckung oder Beschichtung, zur Erzeugung zumindest eines optisch und/oder haptisch wahrnehmbaren Bediensymbols (46) zur Bedienerführung, und
- Zuweisen zumindest eines auszuwertenden Feldes (60) für Bedienereingaben auf der Sensorschicht (22) in Abhängigkeit von einer Größe und/oder Anordnung des zumindest einen optisch und/oder haptisch wahrnehmbaren Bediensymbols (46) zur selektiven Bedienerführung.

## Claims

1. A method for selective operator guidance for operator inputs in a domestic appliance (10), comprising the following steps:
- providing a panel component (14) comprising a sensor layer (22) which is covered by a cover layer (20), which extends areally, and which is configured to detect operator inputs in the form of operator gestures, wherein the sensor layer (22) is sectionally activatable, wherein the panel component (14) comprises a basic configuration and can be controlled variant-specifically,
- defining a present input mode, comprising:
- flexibly, software-based or circuit-based, allocating at least one defined field (60) to be evaluated, which corresponds to a portion of the sensor layer (22), for operator inputs in the form of operator gestures, on the sensor layer (22), depending on the desired input mode,
- activating at least one discrete indicator element (30) of an indicator layer (24) which is arranged on that side of the sensor layer (22) which is facing away from the cover layer (20), for indicating the field (60) to be evaluated of the sensor layer (22),
wherein the at least one discrete indicator element (30) is a non-pixel based indicator element, and
- detecting and evaluating operator inputs in the field (60) to be evaluated.

2. The method as claimed in claim 1, wherein the step of defining the present input mode further comprises the following step:
- assigning the field (60) to be evaluated for operator inputs to an operating symbol (46), which can be perceived optically and/or haptically on the cover layer (20).

3. The method as claimed in one of the preceding claims, further comprising:
- outputting visual feedback to the operator, in response to an operator input, by selectively activating at least one discrete, non-pixel based indicator element (30) of the indicator layer (24).

4. A panel component (14) for an operating panel (12) for a domestic appliance (10) for performing a method of claim 1, the panel component (14) comprising the following:
- a cover layer (20),
- a sectionally activatable sensor layer (22), which covers a rear side of the cover layer (20) areally, at least sectionally,
- an indicator layer (24) comprising at least one discrete indicator element (30),
wherein the at least one discrete indicator element (30) is a non-pixel based indicator element,
wherein the sensor layer (22) is interposed between the cover layer (20) and the at least one discrete, non-pixel based indicator element (30),
wherein the panel component (14) comprises a basic configuration and can be controlled variant-specifically,
wherein the sensor layer (22) is configured to detect operator inputs in the form of operator gestures, wherein the sensor layer (22) is sectionally activatable depending on a desired input mode, wherein for operator inputs on the sensor layer (22) at least one defined field (60) to be evaluated, which corresponds to a portion of the sensor layer (22), can be allocated flexibly, software-based or circuit-based,
and
wherein the at least one discrete, non-pixel based indicator element (30) is actuable for selective operator guidance.

5. The panel component (14) as claimed in claim 4, wherein the sensor layer (22) is arranged as a capacitive sensor layer (22) and configured to detect touches on the cover layer (20) and/or approaches to the cover layer (20) in the region of the sensor layer (22).

6. The panel component (14) as claimed in claim 4 or 5, further comprising an interface (36) for a control device (42), which is configured to actuate selectively the sensor layer (22) and the at least one discrete, non-pixel based indicator element (30) in order to define a plurality of in-put modes, wherein the controller (42) is configured to define a present input mode and to assign, taking into account at least one selected input mode, at least one operator input field (60) to be evaluated on the sensor layer (22).

7. The panel component (14) as claimed in one of claims 4 to 6, comprising at least one non-pixel based indicator element (30) which is arranged as a discrete, selectively activatable symbol (68, 70) or a discrete, selectively activatable segment indicator (72, 76), in particular in the form of a seven-segment indicator.

8. The panel component (14) as claimed in one of claims 4 to 7, wherein the cover layer (20) and the sensor layer (22) are configured so as to be transparent or translucent, at least sectionally, and wherein the cover layer (20) is at least sectionally surface-treated, in particular printed or coated, and wherein the cover layer (20) comprises at least one optically and/or haptically perceivable operating symbol (46) for operator guidance.

9. An operating arrangement (80) for a domestic appliance (10) having a panel component (14) according to one of claims 4 to 8, wherein the operating arrangement (80) comprises a plurality of defined operating regions (82), which are formed in particular on the panel component (14), and wherein at least one field (60) for operator inputs and at least one discrete, non-pixel based display element (30) is assigned to each operating region (82).

10. The operating arrangement (80) according to claim 9, wherein the panel component (14) is configured as an integral panel component (14) into which the operating regions (82) are integrated, wherein at least a first operating region (82a) and a second operating region (82b) are provided, wherein the first operating region (82a) comprises a gesture controllable positioner and discrete, non-pixel based indicator elements (30a) for visually highlighting an operating area, and wherein the second operating region (82b) comprises a multifunctional display with at least one discrete, non-pixel based indicator element (30b) that is configured at least to display a value selected at the first operating region (82a).

11. The operator panel (80) according to claim 10, wherein the discrete, non-pixel based indicator elements (30a) of the first operating region (82a) are adapted to change color or a color gradient in response to an operator input, and wherein the second operating region (82b) is further adapted to detect operator inputs in the form of operator gestures, and to display information in response to the operator inputs.

12. The operating arrangement (80) according to one of the claims 10 or 11, wherein at least one of the operating regions (82) is haptically highlighted, wherein a haptically perceivable highlighting (84) is formed on the cover layer (20), and wherein the haptically perceivable highlighting (84) preferably comprises a recess and/or a projection in the indicated operating region (82).

13. A method for producing a panel component (14) of an operating panel (12) for a domestic appliance (10), wherein the panel component (14) comprises a basic configuration and can be controlled variant-specifically, wherein the method comprises the following steps:
- providing a cover layer (20) made of a plastic material,
- providing an areally extending, sectionally activatable sensor layer (22), which is configured to detect operator inputs in the form of operator gestures,
- providing at least one discrete indicator element (30), wherein the at least one discrete indicator element (30) is a non-pixel based indicator element,
- joining the cover layer (20), the sensor layer (22) and the at least one discrete, non-pixel based indicator element (30), wherein the sensor layer (22) is interposed between the cover layer (20) and the at least one discrete, non-pixel based indicator element (30), and
- providing an interface (36) for a control device (42) for actuating the at least one discrete, non-pixel based indicator element (30) and for evaluating operator inputs detected at the sensor layer (22) for selective operator guidance, and
- flexibly, software-based or circuit-based, allocating at least one field (60) to be evaluated, which corresponds to a portion of the sensor layer (22), for operator inputs on the sensor layer (22), depending on a desired input configuration of the panel component (14).

14. The method as claimed in claim 13, further comprising the following steps:
- processing the cover layer (20), in particular printing or coating, for forming at least one optically and/or haptically perceivable operating symbol (46) for operator guidance, and
- allocating at least one field (60) to be evaluated for operator inputs on the sensor layer (22) depending on a size and/or arrangement of the at least one optically and/or haptically perceivable operating symbol (46) for selective operator guidance.

## Revendications

1. Procédé de guidage d'opérateur sélectif destiné à des entrées d'opérateur dans un appareil ménager (10), le procédé comprenant les étapes suivantes :
- fournir un composant de panneau (14) comprenant une couche de détection (22) qui est recouverte par une couche de revêtement (20), qui s'étend de manière bidimensionnelle et qui est conçue pour détecter des entrées d'opérateur se présentant sous la forme de gestes d'opérateur,
la couche de détection (22) pouvant être activée par endroits,
le composant de panneau (14) ayant une configuration de base et pouvant être commandé d'une manière spécifique à la variante,
- définir un mode d'entrée en cours, comprenant les opérations suivantes :
- affecter de manière flexible, par une technique logicielle ou câblée, au moins une zone définie à évaluer (60), qui correspond à une partie de la couche de détection (22), à des entrées d'opérateur se présentant sous la forme de gestes d'opérateur sur la couche de détection (22) en fonction du mode d'entrée souhaité,
- activer au moins un élément d'affichage discret (30) d'une couche d'affichage (24) disposée du côté de la couche de détection (22) qui est opposé à la couche de revêtement (20) pour identifier la zone à évaluer (60) de la couche de détection (22),
l'au moins un élément d'affichage discret (30) étant un élément d'affichage non à base de pixels, et
- détecter et évaluer des entrées d'opérateur dans la zone à évaluer (60).

2. Procédé selon la revendication 1, l'étape de définition du mode d'entrée en cours comprenant en outre l'étape suivante :
- associer la zone à évaluer (60), destinée aux entrées d'opérateur, à un symbole de commande (46) qui est perceptible de manière visuelle et/ou haptique sur la couche de revêtement (20).

3. Procédé selon l'une quelconque des revendications précédentes, comprenant en outre :
- la délivrance d'un retour visuel à l'opérateur en réponse à une entrée d'opérateur par activation sélective d'au moins un élément d'affichage discret (30) non à base de pixels de la couche d'affichage (24).

4. Composant de panneau (14) destiné à un panneau de commande (12) destiné à un appareil ménager (10) pour mettre en œuvre un procédé selon la revendication 1, le composant de panneau (14) comprenant :
- une couche de revêtement (20),
- une couche de détection (22) pouvant être activée par endroits et recouvrant au moins par endroits de manière bidimensionnelle un côté arrière de la couche de revêtement (20),
- une couche d'affichage (24) pourvue d'au moins un élément d'affichage discret (30), l'au moins un élément d'affichage discret (30) étant un élément d'affichage non à base de pixels,
la couche de détection (22) étant interposée entre la couche de revêtement (20) et l'au moins un élément d'affichage discret (30) non à base de pixels,
le composant de panneau (14) ayant une configuration de base et pouvant être commandé d'une manière spécifique à la variante,
la couche de détection (22) étant conçue pour détecter des entrées d'opérateur se présentant sous la forme de gestes d'opérateur, la couche de détection (22) pouvant être activée par endroits en fonction d'un mode d'entrée souhaité, au moins une zone définie à évaluer (60), qui correspond à une partie de la couche de détection (22), pouvant être affectée de manière flexible, par une technique logicielle ou câblée, à des entrées d'opérateur sur la couche de détection (22) et l'au moins un élément d'affichage discret (30) non à base de pixels pouvant être commandé pour effectuer un guidage d'opérateur sélectif.

5. Composant de panneau (14) selon la revendication 4, la couche de détection (22) étant conçue comme une couche de détection capacitive (22) et étant conçue pour détecter des contacts sur la couche de revêtement (20) et/ou des approches de la couche de revêtement (20) dans la région de la couche de détection (22).

6. Composant de panneau (14) selon la revendication 4 ou 5, comprenant en outre une interface (36) destinée à un dispositif de commande (42) qui est conçu pour commander sélectivement la couche de détection (22) et l'au moins un élément d'affichage discret (30) non à base de pixels, afin de définir une pluralité de modes d'entrée, le dispositif de commande (42) étant conçu pour définir un mode d'entrée en cours et, en prenant en compte au moins un mode d'entrée sélectionné, pour affecter au moins une zone à évaluer (60) destinée à des entrées d'opérateur sur la couche de détection (22).

7. Composant de panneau (14) selon l'une des revendications 4 à 6, comprenant au moins un élément d'affichage (30) non à base de pixels, qui est conçu comme un symbole discret (68, 70) pouvant être activé sélectivement ou comme un affichage à segments discret (72, 76) pouvant être activé sélectivement, notamment comme un affichage à sept segments.

8. Composant de panneau (14) selon l'une des revendications 4 à 7, la couche de revêtement (20) et la couche de détection (22) étant au moins par endroits transparentes ou translucides, et la couche de revêtement (20) étant au moins par endroits traitée en surface, en particulier imprimée ou revêtue, et la couche de revêtement (20) comportant au moins un symbole de commande (46) perceptible de manière visuelle et/ou haptique pour effectuer le guidage d'opérateur.

9. Dispositif de commande (80) destiné à un appareil ménager (10) et comprenant un composant de panneau (14) selon l'une des revendications 4 à 8, le dispositif de commande (80) comprenant une pluralité de régions de commande définies (82) qui sont formées en particulier au niveau du composant de panneau (14), et au moins une zone (60) destinée à des entrées d'opérateur et au moins un élément d'affichage (30) discret, non à base de pixels étant associés à chaque région de commande (82).

10. Dispositif de commande (80) selon la revendication 9, le composant de panneau (14) étant conçu comme un composant de panneau d'intégration (14) dans lequel les régions de commande (82) sont intégrées, au moins une première région de commande (82a) et une deuxième région de commande (82b) étant prévues, la première région de commande (82a) comprenant un actionneur commandable par geste et des éléments d'affichage (30a) discrets, non à base de pixels, destinés à mettre en évidence de manière visuelle une région de réglage, et la deuxième région de commande (82b) comprenant un affichage multifonctionnel pourvu d'au moins un élément d'affichage (30b) discrets, non à base de pixels, qui est au moins conçu pour afficher une valeur sélectionnée au niveau de la première région de commande (82a).

11. Dispositif de commande (80) selon la revendication 10, les éléments d'affichage (30a) discrets, non à base de pixels, de la première région de commande (82a) étant adaptés pour effectuer un changement de couleur ou un changement de dégradé de couleurs en réponse à une entrée d'opérateur, et la deuxième région de commande (82b) étant en outre adaptée pour détecter des entrées d'opérateur se présentant sous la forme de gestes d'opérateur et pour afficher des informations en réponse aux entrées d'opérateur.

12. Dispositif de commande (80) selon l'une des revendications 10 ou 11, au moins une des régions de commande (82) étant mise en évidence de manière haptique, une mise en évidence (84) perceptible de manière haptique étant formée sur la couche de revêtement (20), et la mise en évidence haptique (84) comprenant de préférence une dépression et/ou une élévation dans la région de commande identifiée (82).

13. Procédé de fabrication d'un composant de panneau (14) d'un panneau de commande (12) destiné à un appareil ménager (10), le composant de panneau (14) ayant une configuration de base et pouvant être commandé d'une manière spécifique à la variante, le procédé comprenant les étapes suivantes :
- fournir une couche de revêtement (20) en matière plastique,
- fournir une couche de détection (22) qui peut être activée par endroits, qui s'étend de manière bidimensionnelle et qui est conçue pour détecter des entrées d'opérateur se présentant sous la forme de gestes d'opérateur,
- fournir au moins un élément d'affichage discret (30), l'au moins un élément d'affichage discret (30) étant un élément d'affichage non à base de pixels,
- assembler la couche de revêtement (20), la couche de détection (22) et l'au moins un élément d'affichage discret (30) non à base de pixels, la couche de détection (22) étant interposée entre la couche de revêtement (20) et l'au moins un élément d'affichage discret (30) non à base de pixels, et
- fournir une interface (36) destinée à un dispositif de commande (42) destiné à commander l'au moins un élément d'affichage discret (30) non à base de pixels et à évaluer des entrées d'opérateur détectées au niveau de la couche de détection (22) pour effectuer un guidage d'opérateur sélectif, et
- affecter de manière flexible, par une technique logicielle ou câblée, au moins une zone à évaluer (60), qui correspond à une partie de la couche de détection (22), à des entrées d'opérateur sur la couche de détection (22) en fonction d'une configuration d'entrée souhaitée du composant de panneau (14).

14. Procédé selon la revendication 13, comprenant en outre les étapes suivantes :
- traiter, en particulier imprimer ou revêtir, la couche de revêtement (20) pour générer au moins un symbole de commande (46) perceptible de manière visuelle et/ou haptique pour effectuer le guidage d'opérateur, et
- affecter au moins une zone à évaluer (60) à des entrées d'opérateur sur la couche de détection (22) en fonction d'une taille et/ou d'un agencement de l'au moins un symbole de commande (46) perceptible de manière visuelle et/ou haptique pour effectuer un guidage d'opérateur sélectif.
